# EUROPÄISCHE PATENTSCHRIFT

(11) **EP 0 875 093 B1**
(45) Veröffentlichungstag und Bekanntmachung des Hinweises auf die Patenterteilung: **19.07.2000**
(21) Anmeldenummer: 96944065.0
(22) Anmeldetag: 23.12.1996
(51) Int. Cl.: H03K 19/00, H03K 19/0175

(54) **AUSGANGSPUFFERSCHALTKREIS**
OUTPUT BUFFER SWITCHING CIRCUIT
CIRCUIT TAMPON DE SORTIE

(30) Priorität: 16.01.1996 DE 19601386
(43) Veröffentlichungstag der Anmeldung: 04.11.1998
(60) Teilanmeldung: 99122066.6
(73) Patentinhaber: TELEFONAKTIEBOLAGET LM ERICSSON, 126 25 Stockholm (SE)
(72) Erfinder: HEDBERG, Mats, S-136 72 Haninge (SE)
(74) Vertreter: von Fischern, Bernhard, Dipl.-Ing.
(86) Internationale Anmeldenummer: EP9605827
(87) Internationale Veröffentlichungsnummer: WO9726707

(56) Entgegenhaltungen:
- EP-A- 0 680 148
- WO-A-92/09141
- US-A- 4 074 151
- IEEE JOURNAL OF SOLID-STATE CIRCUITS, Bd. 27, Nr. 12, Dezember 1992, NEW YORK, NY, US, Seiten 1723-1729, XP000329021 H. KHORRAMABADI ET AL.: "A Highly Efficient CMOS Line Driver with 80-dB Linearity for ISDN U-Interface Applications"
- IEEE JOURNAL OF SOLID-STATE CIRCUITS, Bd. 25, Nr. 2, April 1990, NEW YORK, NY, US, Seiten 546-554, XP000116700 L. TOMASINI ET AL.: "A Fully Differential CMOS Line Driver for ISDN"
- MAXIM Engineering Journal, Ausgabe 17, Januar 1995, Spezial-Electronic KG, Bückeburg, Seiten 3-7 "Stromversorgungen für Pentium, PowerPC und mehr"

## Beschreibung

Die vorliegende Erfindung betrifft einen Ausgangspufferschaltkreis zum Ausgeben von digitalen Signalen.

Gegenwärtig ist eine Vielzahl von Konzepten für digitale Logikschaltungen und den Austausch von digitalen Signalenzwischenschaltkreisen bekannt. Frühe Konzepte sind DTL (Diode-Transistor-Logik), TTL (Transistor-Transistor Logik) und ECL (Emitter Coupled Logic), welche Konzepte in digitalen Logikschaltungen und auch für den Austausch von Signalen zwischen Schaltungen oder Schaltungsplatinen verwendet werden.

Konzepte, welche für die Übertragung von digitalen Daten mit hoher Datenrate ausgelegt sind, verwenden bevorzugt differentielle Übertragung und differentiellen Empfang von digitalen Daten, unter Verwendung eines Paares von Signalübertragungsleitungen. DPECL (Differential Positive Emitter Coupled Logic), LVDS (Low Voltage Differential Signalling) und GLVDS (Grounded Low Voltage Differential Signalling) sind Beispiele für Signalübertragungskonzepte, welche differentielle Signalübertragung verwenden. Differentielle Signalübertragung ermöglicht es, die differentielle Spannung über dem Paar von Signalübertragungsleitungen niedrig zu halten, weil aufgrund des differentiellen Konzeptes Störspannungsabfälle entlang einer Masseleitung, welche den Sender mit dem Empfänger verbindet, die Qualität der Datenübertragung nicht nachteilig beeinflussen. Niedrige differentielle Signalspannungen wiederum halten die Leistung, die über Übertragungsleitungen mit niedriger Impedanz übertragen wird, innerhalb vernünftiger Grenzen.

Mit der ständig wachsenden Komplexität von Digitalschaltungen zusammen mit einem schnellen Anstieg des Integrationsgrades wird die Leistungseffizienz eines Schaltkreisentwurfes immer wichtiger. Bei einem spezifizierten Grenzwert für die Verlustleistungsdichte (Verlustleistung pro Einheitsfläche), ist die maximal zulässige Verlustleistung einer jeden Schaltkreiskomponente je niedriger, desto höher die Integrationsdichte ist. Umgekehrt gilt, daß je größer die Verlustleistung eines speziellen Komponente ist, desto größer die Fläche ist, die durch diese Komponente auf einem Halbleiterchip belegt wird.

Verlustleistung ist insbesondere dann ein Problem, wenn Ausgangspufferstufen mit niedriger Impedanz konstruiert werden, die in einer Systemumgebung arbeiten, deren Versorgungsspannungen höher sind als die differentielle spannungsamplitude über den Ausgangsanschlüssen des Ausgangspufferschaltkreises. In diesem Fall resultieren vergleichsweise hohe, von dem Pufferschaltkreis ausgegebene Ströme in großen Verlustleistungsbeträgen in den Ausgangsstufen des Puffers.

All die oben erwähnten differentiellen Signalübertragungskonzepte arbeiten bei festen Nominalspannungen bezüglich Masse. Jede Leitung arbeitet mit zwei Spannungspegeln, die Niederspannungspegel bzw. Hochspannungspegel genannt werden. Beispielsweise arbeitet DPECL mit einem Niederspannungspegel von 3,3 Volt und einem Hochspannungspegel von 4,1 Volt. LVDS hat andererseits einen Niederspannungspegel von 1,6 Volt und einen Hochspannungspegel von 1,4 Volt. GLVDS arbeitet mit Signalpegeln nahe am Massepotential, beispielsweise 0 Volt und 0,2 Volt oder näherungsweise symmetrisch bezüglich Masse, mit einer Amplitude von ungefähr 0,2 Volt.

Unter Berücksichtigung aller gegenwärtig verfügbaren, differentiellen Signalübertragungskonzepte erstrecken sich die Signalübertragungspannungen von geringfügig weniger als 0 Volt bis hinauf zu mehr als 4 Volt. Als Folge ist es nicht möglich, einen Ausgangspufferschaltkreis, der einem differentiellen Signalübertragungskonzept gehorcht, mit einem Eingang zu verbinden, der zu einem anderen, verschiedenen Signalübertragungskonzept gehört. Demgemäß muß ein komplexer Schaltungsentwurf entweder bei einem speziellen Signalübertragungskonzept bleiben, oder muß Einrichtungen zum Übersetzen zwischen den verschiedenen Signalübertragungspegeln einschließen. Die erste Alternative hat den Nachteil, daß zukünftige Entwicklungen wenig flexibel sind, während die letzte Alternative zusätzlichen Raum und zusätzliche Leistung erfordert, ohne zu den Kernfunktionen des Systems beizutragen.

Aus MAXIM Engineering Journal, Ausgabe 17, Januar 1995, Spezial-Elektronik KG, Bückeburg, Seiten 3-7 "Stromversorgungen für Pentium, Power PC und mehr" ist ein Stromversorgungsabschnitt zum Liefern von Leistung an CPUs bekannt, welcher umfaßt: ein Paar von Eingangsanschlüssen zur Verbindung mit einer Spannungsquelle und ein Paar von Ausgangsanschlüssen, die mit der CPU verbunden sind; Reaktanzeinrichtungen zum zeitweiligen Speichern von Energie; und Schalteinrichtungen, die angepaßt sind, eine Ladephase vorzusehen, in welcher Energie von der Spannungsquelle in die Reaktanzeinrichtungen geladen wird, sowie eine Entladephase, in welcher wenigstens ein Teil der in den Reaktanzeinrichtungen gespeicherten Energie in die Ausgangsanschlüsse entladen wird. Aus diesem Dokument ist es ferner bekannt, die Abschlußwiderstände eines Busses mit Gunning-Transceiver-Logik (GTL) mittels eines DC-DC-Abwärtswandlers zu versorgen. Des weiteren ist es aus diesem Dokument bekannt, daß die PC-Stromversorgung eine dezentrale Struktur lokaler DC-DC-Wandler auf der Hauptplatine versorgt, um IR-Verluste und induktive Effekte auszuschließen.

Die vorliegende Erfindung zielt darauf ab, die oben erläuterten Probleme zu lösen. Es ist die Aufgabe der Erfindung, einen leistungseffizienten Ausgangspufferschaltkreis vorzusehen, der geeignet ist, Übertragungsleitungen mit niedriger Impedanz mit hohen Datenraten anzusteuern, und eine platzsparende Implementierung auf einem Halbleiterchip ermöglicht.

Es ist eine weitere Aufgabe der vorliegenden Erfindung, einen Ausgangspufferschaltkreis vorzusehen, welcher zur Kooperation mit einer Vielzahl von verschiedenen Signalübertagungskonzepten mit verschiedenen Spannungspegeln geeignet ist, ohne daß die Leistungseffizienz schlechter wird oder zusätzlicher Platz auf der Chipoberfläche belegt wird.

Die Lösung dieser Aufgabe ist im Anspruch 1 angegeben.

Ein Ausgangspufferschaltkreis zum Ausgeben von digitalen Signalen gemäß der vorliegenden Erfindung umfaßt einen Verstärkerabschnitt zum Treiben einer symmetrischen Übertragungsleitung niedriger Impedanz und umfaßt darüber hinaus einen Stromversorgungsabschnitt zum Versorgen des Verstärkerabschnittes mit Strom. Der Stromversorgungsabschnitt umfaßt ein Paar von Eingangsanschlüssen zur Verbindung mit einer Spannungsquelle und ein Paar von Ausgangsanschlüssen zur Verbindung mit dem Verstärkerabschnitt; Reaktanzeinrichtungen zum zeitweiligen Speichern von Energie; und Schalteinrichtungen, welche angepaßt sind, eine Ladephase vorzusehen, in welcher Energie von der Spannungsquelle in die Reaktanzeinrichtungen geladen wird, sowie eine Entladephase, in welcher wenigstens ein Teil der in den Reaktanzeinrichtungen gespeicherten Energie in die Ausgangsanschlüsse entladen wird. Der Verstärkerabschnitt und wenigstens die Schalteinrichtungen des Versorgungsabschnittes sind auf einem gemeinsamen Halbleiterchip integriert.

Gemäß der vorliegenden Erfindung empfängt eine Reaktanzeinrichtung, beispielsweise eine Induktivität oder eine Kapazität, Energie von einer Spannungsquelle während einer Ladephase und reicht diese Energie während einer Entladephase an den Verstärkerabschnitt weiter. Durch geeignetes Einstellen der Dauer der Ladephase und der Dauer der Entladephase ist es möglich, den Verstärkerabschnitt mit einer Versorgungsspannung zu versehen, die für einen leistungseffizienten Betrieb geeignet ist, ohne daß viel Leistung in Wärme umgesetzt wird. Dieses ist möglich, weil eine geeignete Einstellung der Dauer der Ladephase in Beziehung zur Dauer der Entladephase es möglich macht, gerade soviel Leistung an den Verstärkerabschnitt zu übertragen, wie zum ordnungsgemäßen Betrieb erforderlich ist, ohne daß unnötige Leistung in dem Stromversorgungsabschnitt oder in dem Verstärkerabschnitt verloren geht.

Gemäß einem speziellen Ausführungsbeispiel der vorliegenden Erfindung umfaßt die Schalteinrichtung, die angepaßt ist, die Ladephase und die Entladephase vorzusehen, einen ersten halbleiterschalter zum Durchführen der Ladephase, der zwischen einen Eingangsanschluß des Paares von Eingangsanschlüssen und einen ersten Anschluß der Reaktanzeinrichtungen geschaltet ist. Darüber hinaus umfaßt die Schalteinrichtung einen zweiten Halbleiterschalter zum Durchführen der Entladephase, der zwischen den ersten Anschluß der Reaktanzeinrichtungen und einen Ausgangsanschluß des Paares von Ausgangsanschlüssen geschaltet ist. Der zweite Anschluß der Reaktanzeinrichtungen ist mit dem anderen Ausgangsanschluß des Paares von Ausgangsanschlüssen verbunden. Auf diese Weise stellt der erste Schalter während der Ladephase eine Schleife her, welche die mit den Eingangsanschlüssen des Stromversorgungsabschnittes verbundene Spannungsquelle und die Reaktanzeinrichtungen einschließt. Diese Schleife kann ebenfalls die Last in Gestalt des Verstärkerabschnittes einschließen. Während der Entladephase stellt der zweite Schalter eine Schleife her, welche die Reaktanzeinrichtungen und die Last einschließt. Dieses Ausführungsbeispiel ist vorteilhaft für LVDS (Low Voltage Differential Signalling) Anwendungen, GLVDS (Grounded Low Voltage Differential Signalling) und DPECL (Differential Positive Emitter Coupled Logic).

Gemäß einem anderen speziellen Ausführungsbeispiel der vorliegenden Erfindung sorgt die Schalteinrichtung, die angepaßt ist, die Ladephase und die Entladephase vorzusehen, für die Trennung beider Eingangsanschlüsse des Stromversorgungsabschnittes von beiden Ausgangsanschlüssen des Stromversorgungsabschnittes sowohl während der Ladephase als auch während der Entladephase. Auf diese Weise "schwimmt" die Spannung über den Ausgangsanschlüssen bezüglich der Spannung über den Eingangsanschlüssen des Stromversorgungsabschnittes. "Schwimmen" bedeutet hier, daß eine Spannung, die über einen der beiden Eingangsanschlüsse und einen der beiden Ausgangsanschlüsse des Stromversorgungsabschnittes gelegt wird, nicht in einem Strom von dem jeweiligen Eingangsanschluß zu dem jeweiligen Ausgangsanschluß resultiert. Mit anderen Worten ist der Betrieb des Stromversorgungsabschnittes unabhängig von der Anlegung solcher Spannungen. Diese Eigenschaft des Stromversorgungsabschnittes ermöglicht es, eine große Vielfalt von Eingangsstufen, welche verschiedenen Signalübertragungskonzepten gehorchen, anzusteuern, ohne daß der Ausgangspufferschaltkreis modifiziert werden muß. Der Gleichtaktspannungspegel des Verstärkerausganges bezüglich eines beliebigen Bezugspunktes, beispielsweise eines der Eingangsanschlüsse des Stromversorgungsabschnittes, kann vollständig von der Eingangsstufe bestimmt werden, die mit dem Ausgang des Verstärkerabschnittes verbunden ist, ohne den Betrieb des Stromversorgungsabschnittes oder des Verstärkerabschnittes nachteilig zu beeinflussen. Dieses macht es möglich, flexibel verschiedene Signalübertagungskonzepte zu kombinieren, ohne die Notwendigkeit einer strom- und platzkonsumierenden Pegelumwandlung.

Bevorzugt hat der Verstärkerabschnitt differentielle Eingänge, welche einen großen Gleichtakt-Betriebsbereich ermöglichen. Falls gewünscht, können diese differentiellen Eingänge von einer Vorverstärkerstufe angesteuert werden, welche nicht von dem oben beschriebenen "schwimmenden" Stromversorgungsabschnitt mit Strom versorgt wird, sondern von einer Stromversorgung, welche einen Bezug zur Systemmasse hat. Diese Vorverstärkerstufe kann dann als Schnittstelle zwischen Einzelleitungssignalübertragung mit Massebezug und dem schwimmenden Verstärkerabschnitt dienen, welcher schwimmende differentielle Signale ausgibt, d.h. differentielle Signale, welche im Prinzip einen beliebigen Gleichtaktspannungspegel bezüglich Masse haben.

Es kann vorteilhaft sein, einen Stromversorgungsabschnitt für eine Vielzahl von verschiedenen Verstärkerabschnitten und Signalkanälen vorzusehen.

Im folgenden wird die vorliegende Erfindung detaillierter unter Bezugnahme auf die begleitenden Zeichnungen beschrieben.
- Figur 1: zeigt ein schematisches Blockdiagramm eines Ausgangspufferschaltkreises gemäß der vorliegenden Erfindung.
- Figuren 2a bis 2c: zeigen schematische Diagramme, welche das grundlegende Arbeitsprinzip des Stromversorgungsabschnittes eines Ausgangspufferschaltkreises gemäß einem ersten Ausführungsbeispiel und Modifikationen davon zeigen.
- Figur 3: zeigt ein Zeitdiagramm.
- Figur 4: zeigt ein schematisches Diagramm, welches die grundlegende Struktur eines Verstärkerabschnittes eines Ausgangspufferschaltkreises gemäß der vorliegenden Erfindung zeigt.
- Figur 5: zeigt den Stromversorgungsabschnitt eines Ausgangspufferschaltkreises gemäß einem zweiten Ausführungsbeispiel der vorliegenden Erfindung.
- Figur 6: zeigt den Stromversorgungsabschnitt eines GLVDS Ausgangspufferschaltkreises gemäß einem dritten Ausführungsbeispiel der vorliegenden Erfindung.
- Figur 7: zeigt ein Blockdiagramm zum Erläutern der Verbindungen zwischen dem Stromversorgungsabschnitt und dem Verstärkerabschnitt.
- Figur 8: zeigt den Stromversorgungsabschnitt eines Ausgangspufferschaltkreises gemäß einem vierten Ausführungsbeispiel der Erfindung.
- Figur 9: zeigt ein Ausführungsbeispiel des Pufferverstärkerabschnittes des Ausgangspufferschaltkreises gemäß der vorliegenden Erfindung.
- Figur 10: zeigt ein Ausführungsbeispiel von Steuereinrichtungen zum Steuern des Schaltzustandes der Schalter des Stromversorgungsabschnittes gemäß den ersten bis dritten Ausführungsbeispielen.
- Figur 11: zeigt ein Ausführungsbeispiel von Steuereinrichtungen zum Steuern des Schaltzustandes der Schalter des Stromversorgungsabschnittes gemäß dem vierten Ausführungsbeispiel.
- Figur 12: zeigt eine Tabelle zum Erläutern des Betriebs der Schalter der Figuren 2a bis 2c, 4, 6 bzw. 8.

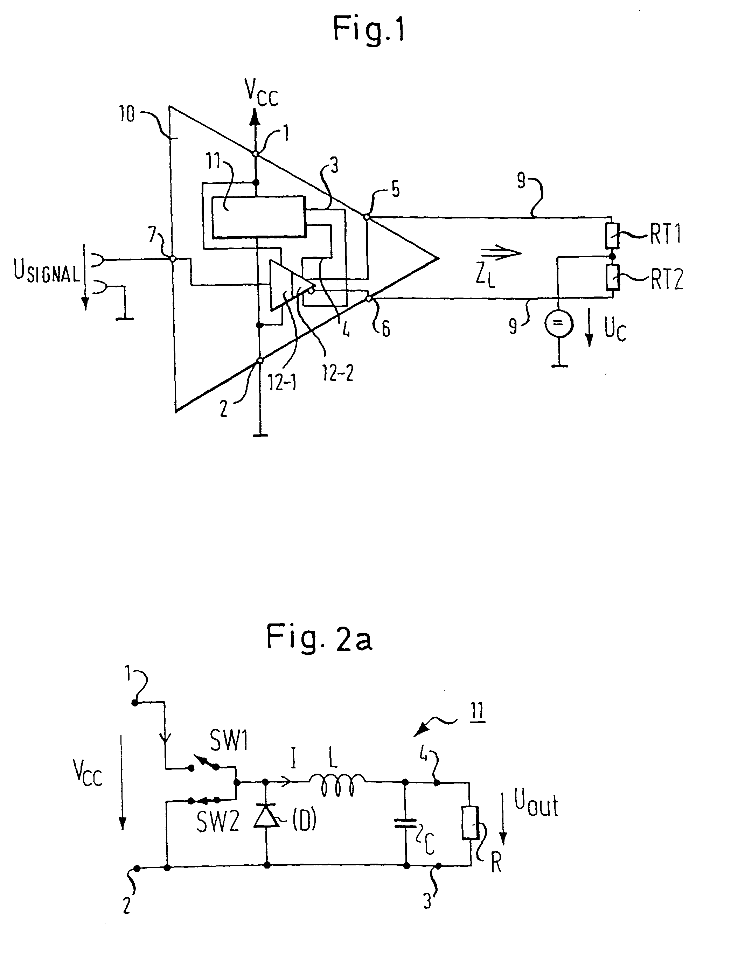

Figur 1 zeigt ein übersichtartiges Blockdiagramm des Ausgangspufferschaltkreises gemäß der vorliegenden Erfindung. Dieser Ausgangspufferschaltkreis 10 umfaßt einen Verstärker 12 mit einem Vorverstärkerabschnitt 12-1 und einem Verstärkerabschnitt 12-2. Der Eingang 7 des Vorverstärkerabschnittes 12-1 empfängt ein Eingangssignal U_{Signal} zur Übertragung über eine Übertragungsleitung 9 an einen Eingangspuffer, der schematisch durch RT1, RT2 und Uc dargestellt ist. Die dargestellte Übertragungsleitung 9 repräsentiert eine symmetrische Übertragungsleitung oder die Signalleitungen eines Paares von asymmetrischen Übertragungsleitungen. Im folgenden wird der Begriff "Übertragungsleitung" für eine symmetrische Übertragungsleitung verwendet, beispielsweise twisted pair, oder für zwei asymmetrische Übertragungsleitungen, beispielsweise zwei koaxiale Leitungen mit geerdeter Abschirmung. Beide Alternativen sind im folgenden für die Übertragung differentieller Signale allgemein anwendbar. Die Übertragungsleitung 9 ist mit den differentiellen Ausgängen 5 und 6 des Verstärkerabschnittes 12-2 verbunden, wobei diese Ausgänge 5 und 6 die Ausgangsanschlüsse des Ausgangspufferschaltkreises 10 bilden. Unter der Annahme, daß die Übertragungsleitung 9 durch die Eingangsstufe ordnungsgemäß abgeschlossen ist, "sieht" der Ausgangspufferschaltkreis den Wellenwiderstand Z_{L}. U_{C} ist eine Spannungsquelle, welche schematisch einen Gleichtaktspannungspegel auf der Übertragungsleitung 9 darstellt. Diese Spannungsquelle kann auf der Seite des Ausgangspufferschaltkreises 10 oder auf der Seite des Eingangsschaltkreises (wie in der Figur dargestellt) angeordnet sein, abhängig davon, ob es der Ausgangspuffer ist, welcher den Gleichtaktspannungspegel bestimmt, oder der Eingangspuffer. Sie kann 0 Volt haben (Kurzschluß) oder überhaupt nicht vorhanden sein. Welcher dieser Fälle anwendbar ist, wird im folgenden unter Bezugnahme auf die jeweiligen Ausführungsbeispiele diskutiert.

Bezugziffer 11 bezeichnet einen Stromversorgungsabschnitt, um den Verstärkerabschnitt 12-2 mit Strom zu versorgen. Dieser Stormversorgungsabschnitt 11 umfaßt ein Paar von Eingangsanschlüssen 1, 2, die mit einer (nicht gezeigten) Spannungsquelle verbunden sind, welche eine Versorgungsspannung V_{CC} bereitstellt. Darüber hinaus weist der Stromversorgungsabschnitt 11 Ausgangsanschlüsse 3, 4 auf, die mit dem Verstärkerabschnitt 12-2 verbunden sind. Dieser Verstärkerabschnitt 12-2 wird von den Ausgangsanschlüssen 3, 4 des Stromversorgungsabschnittes 11 mit Strom versorgt und bildet somit eine Last, die über die Ausgangsanschlüsse 3, 4 des Stromversorgungsabschnittes 11 geschaltet ist. Der Vorverstärkerabschnitt 12-1 empfängt eine Versorgungsspannung mit Bezug zur Masse 2. Auf diese Weise kann der Vorverstärkerabschnitt 12-1 eine Umwandlung zwischen Einzelleitungs-Signalübertragung mit Massebezug und differentieller Signalübertragung durchführen. Natürlich kann die Vorverstärkerstufe 12-1 ausgelassen werden, wenn eine Umwandlung zwischen Einzelleitungs-Signalübertragung und differentieller Signalübertragung nicht erforderlich ist. Dieses kann beispielsweise der Fall sein, wenn das Eingangssignal U_{Signal} ein differentielles Zweidraht-Eingangssignal ist.

Im Betrieb steuert der Verstärkerabschnitt 12-2 die Übertragungsleitung Z_{L} niedriger Impedanz mit differentiellen Signalen an, welche dem Eingangssignal U_{Signal} entsprechen. Die Amplitude des differentiellen Ausgangssignals, d.h. die Spannungsamplitude über den Ausgangsanschlüssen 5 und 6, ist gerade so hoch, wie für eine zuverlässige Datenübertragung erforderlich ist, um die über die Übertragungsleitung 9 übertragene Leistung so niedrig wie möglich zu halten. Typische Werte der differentiellen Spannungsamplitude über den Ausgangsanschlüssen 5 und 6 liegen im Bereich zwischen 100 mV und 500 mV.

Im Idealfall liefert der Stromversorgungsabschnitt nicht mehr Leistung an die Ausgangsstufen des Verstärkerabschnittes 12-2 als in die Übertragungsleitung 9 eingespeist wird. Auf diese Weise kann eine unnötige Verlustleistung in den Ausgangsstufen des Verstärkerabschnittes 12-2 vermieden werden und die Ausgangsstufe kann klein gehalten werden.

Natürlich wird eine reale Ausgangsstufenkonstruktion abhängig von dem Typ der in der Ausgangsstufe des Verstärkerabschnittes 12-2 verwendeten Halbleiter-Signalschalter einen gewissen minimalen Leistungsbetrag in Wärme umsetzen. Das gleiche gilt, wenn von der Ausgangsstufe verlangt wird, eine Quellimpedanzanpassung vorzusehen. Jedoch ist gemäß der vorliegenden Erfindung der Verstärkerabschnitt 12-2, welcher die Übertragungsleitung 9 ansteuert, nicht notwendigerweise verantwortlich für die Begrenzung der übertragenen Leistung, sondern kann konstruiert sein, primär das Vorzeichen der übertragenen elektrischen Signale zu bestimmen, während die Leistungsbegrenzung in dem Stromversorgungsabschnitt 11 stattfindet. Der Stromversorgungsabschnitt 11 wiederum ist nicht unbedingt für die Signalübertragung verantwortlich und kann auf maximalen Wirkungsgrad konstruiert sein.

Figur 2a zeigt ein schematisches Diagramm zum Erläutern des grundlegenden Arbeitsprinzips des Stromversorgungsabschnittes 11 gemäß einem ersten Ausführungsbeispiel der vorliegenden Erfindung.

Dieses schematische Diagramm umfaßt eine Induktivität L, welche als Einrichtung zum zeitweiligen Speichern von Energie arbeitet, und schließt darüber hinaus Schalter SW1 und SW2 zum Steuern des Ladens von Energie von einer (nicht gezeigten) Stromquelle, welche mit den Anschlüssen 1 und 2 verbunden ist, in die Induktivität L und des Entladens der in der Induktivität L gespeicherten Energie in den mit den Anschlüssen 3 und 4 verbundenen Verstärkerabschnitt 12-2 ein, welcher schematisch durch einen Widerstand R dargestellt ist. In diesem Ausführungsbeispiel ist der Schalter SW1 zwischen die Induktivität L und den Stromversorgungsanschluß 1 geschaltet, welcher eine Versorgungsspannung V_{CC} bereitstellt, und steuert die Ladephase, während der Schalter SW₂ die Entladephase steuert.

Zu diesem Zweck ist in diesem Ausführungsbeispiel der Schalter SW2 zwischen dem anderen Stromversorgungsanschluß 2 und denjenigen Anschluß der Induktivität L geschaltet, welcher mit SW1 verbunden ist. Ein Kondensator C kann zum Glätten der an die Last R gelieferten Spannung vorgesehen sein. Eine Diode D kann über den Schalter SW2 geschaltet sein, um als Freilaufdiode zu dienen, oder kann den Schalter SW₂ ersetzen, um selbst als Schalter zu wirken. Sowohl die Diode D als auch der Kondensator C sind vorteilhaft, jedoch für den grundlegenden Betrieb dieses Schaltkreises nicht erforderlich.

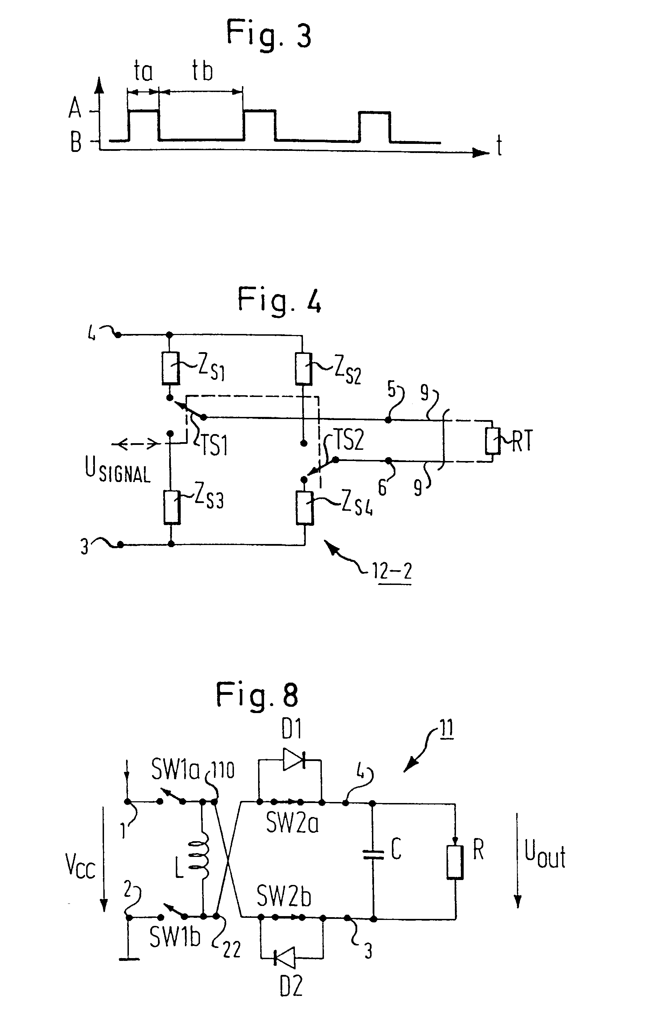

Figur 3 zeigt ein Zeitdiagramm, um den grundlegenden Betrieb des Schaltkreises der Figur 2a zu erläutern. Dieses Diagramm zeigt eine Abwechslung zwischen einer ersten Phase A, welche die Ladephase darstellt, in welcher die in der Induktivität L gespeicherte Energie vergrößert wird, und einer Entladephase B, in welcher in der Induktivität L gespeicherte Energie in den Verstärkerabschnitt 12-2 entladen wird. Die Dauer der Ladephase A ist mit ta bezeichnet, während die Dauer der Entladephase B mit tb bezeichnet ist.

Der Zustand der Schalter SW1 und SW2 ist abhängig von den Phasen A und B. In der Ladephase A ist der Schalter SW1 in leitendem Zustand, während der Schalter SW2 in einem nichtleitenden Zustand ist. Während dieser Phase tritt die zwischen den Stromversorgungseingangsanschlüssen 1 und 2 angelegte versorgungsspannung V_{CC} über der Reihenschaltung der Induktivität L und der Last R auf, was in einem Strom I resultiert, der von dem Stromversorgungseingangaschluß 1 durch den Schalter SW1, die Induktivität L zu dem Ausgangsanschluß 4, durch den Verstärkerabschnitt 12-2, dargestellt durch R, durch den Ausgangsanschluß 3 zurück zum Stromversorgungseingangsanschluß 2 fließt. In dieser Ladephase A wird die von der Spannungsquelle an den Anschlüssen 1 und 2 gelieferte Leistung teilweise an die Last R geliefert und teilweise erhöht sie die in der Induktivität L gespeicherte Energie. Unter der Annahme idealer Komponenten gibt es in dieser Phase keine Verlustleistung.

Nach dem Ablauf der Zeit ta wechselt der Schalter SW1 in einen nicht leitenden Zustand, um die Ladephase A zu beenden, und der Schalter SW2 wechselt in einen leitenden Zustand, um die Entladephase B zu beginnen. In dieser Phase fließt der Strom I weiterhin durch die Induktivität L, durch die Last R und durch den Schalter SW2 zurück zur Induktivität L. Während dieser Phase entlädt die Induktivität L zumindest einen Teil der während der Phase akkumulierten Energie in die Last R und liefert somit Leistung an den Verstärkerabschnitt 12-2. Auch in dieser Phase gibt es unter der Annahme idealer Komponenten keine Verlustleistung. Darüber hinaus entspricht im eingeschwungenen Zustand die während der Ladephase A in die Induktivität hineinfließende Energiemenge der Energiemenge, die während der Entladephase B in die Last R entladen wird. Je kürzer die Ladephase relativ zur Gesamtdauer ta+tb von Ladephase und Entladephase ist, desto weniger Energie wird von der spannungsquelle V_{cc} über den Eingangsanschlüssen 1 und 2 zu den Ausgangsanschlüssen 3 und 4 und in die Last R übertragen. Demgemäß ermöglicht die geeignete Einstellung des Tastverhältnisses ta/(ta+tb) die Einstellung der in die Last R, d.h., in den Verstärkerabschnitt 12-2 fließenden Leistung, ohne daß in dem Stromversorgungsabschnitt 11 Leistung verloren geht.

Um einen Kurzschluß zwischen den Stromversorgungsanschlüssen 1 und 2 zu vermeiden, überlappen sich die leitenden Zustände der Schalter SW1 und SW2 vorteilhaftermaßen nicht. Dieses kann zu einer zeitlichen Überlappung der nicht leitenden Zustände der Schalter SW1 und SW2 führen. In dieser Situation kann eine Freilaufdiode D, die über den Schalter SW2 geschaltet ist, den Kreis für den Strom I schließen, der von der Induktivität L erzwungen wird. Wenn die Verlustleistung in der Diode D aufgrund der Vorwärtsspannung über der Diode in dieser Phase tolerierbar ist, kann der Schalter SW2 ausgelassen werden. Die prinzipielle Funktion des Schalters SW₂ wird dann von der Diode D übernommen.

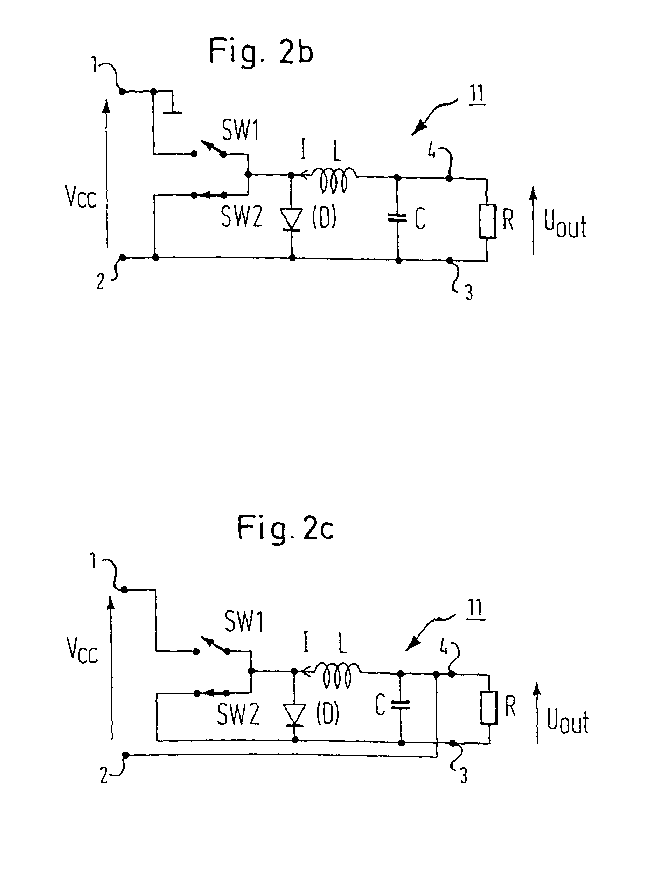

Figur 2b zeigt eine erste Modifikation des in Figur 2a gezeigten Stromversorgungsabschnittes 11, welcher vorteilhaft verwendet werden kann, wenn der Ausgangspufferschaltkreis Niederspannugns- und Hochspannungsignalpegel erzeugen soll, die gerade unterhalb des Versorgungsspannungspotentials V_{CC} liegen. Merkmale und Funktion dieser Modifikation entsprechen dem Ausführungsbeispiel der Figur 2a, außer daß der Anschluß 1 des Schaltkreises der Figur 2b mit Masse verbunden ist, der Anschluß 2 mit V_{CC} verbunden ist und die Diode D, falls vorhanden, umgedreht ist. Dann weist der Anschluß 3 bezüglich Masse V_{CC} Potential auf, während der Anschluß 4 ein um die Spannung über R geringeres Potential als V_{CC} bezüglich Masse aufweist.

Figur 2c zeigt eine zweite Modifikation des in Figur 2a dargestellten Stromversorgungsabschnittes 11, welche vorteilhaft verwendet werden kann, wenn der Ausgangspufferschaltkreis Niederspannungs- und Hochspannungssignalpegel erzeugen soll, die gerade oberhalb des Versorgungsspannungspotentials V_{CC} liegen. Merkmale und Funktion dieser Modifikation entsprechen dem Ausführungsbeispiel der Figur 2a, außer daß Anschluß 1 des Schaltkreises der Figur 2c mit Masse verbunden ist, Anschluß 2 mit V_{CC} verbunden ist, und die Diode D, falls vorhanden, umgedreht ist. Ferner ist der Eingangsanschluß 2 nicht direkt mit Anschluß 3, sondern mit Anschluß 4 verbunden, so daß während der Ladephase A die volle Versorgungsspannung V_{CC}, die über den Spannungsversorgungsanschlüssen 1 und 2 angelegt ist, über der Induktivität L auftritt. Während dieser Phase A sorgt der Kondensator C für den Erhalt der Spannung über der Last R, Gemäß dieser Modifikation weist der Ausgangsanschluß 4 V_{CC} Potential auf, während das Potential des Anschlusses 3 um die Spannung über der Last R höher ist als das Potential des Anschlusses 4. Diese Modifikation ist beispielsweise insbesondere zum Ansteuern eines Empfängers gemäß dem 5 Volt DPECL Standard geeignet, wobei der Ausgangspufferschaltkreis mit einer Versorgungsspannung V_{CC} von 3,3 Volt arbeitet.

Figur 4 zeigt ein schematisches Diagramm zum Erläutern der grundlegenden Struktur eines Ausführungsbeispiels des Verstärkerabschnittes 12-2 gemäß der vorliegenden Erfindung. Dieser Verstärkerabschnitt 12-2 umfaßt Stromversorgungsanschlüsse 3 und 4, die mit dem Stromversorgungsabschnitt 11 verbunden sind, und schließt ferner Signalausgangsanschlüsse 5 und 6 ein, die mit einem Abschlußwiderstand RT beispielsweise über eine Übertragungsleitung 9 verbunden sind. Der Verstärkerabschnitt 12-2 schließt ferner einen Umschalter TS1 ein, der mit dem Signalausgangsanschluß 5 verbunden ist, und einen Umschalter TS2, der mit dem Signalausgangsanschluß 6 verbunden ist, um die Signalausgangsanschlüsse 5 und 6 abwechselnd mit einem jeweiligen der mit dem Stromversorgungsabschnitt 11 verbundenen Stromversorgungsausgangsanschlüsse 3, 4 zu verbinden. Die Impedanzen Zₛ₁ bis z_{S4} stellen Zweigimpedanzen dar, die zwischen die jeweiligen Umschalter und die jeweiligen Ausgangsanschlüsse 3, 4 des Stromversorgungsabschnittes 11 geschaltet sind. Wie durch die gestrichelte Linie angedeutet, werden die Positionen der Umschalter TS1 und TS2 gemäß dem Eingangssignal U_{Signal} bestimmt, das an einen (nicht gezeigten) Empfänger zu übertragen ist. Abhängig von dem logischen Pegel des Signals U_{Signal} sorgen die Umschalter TS1 und TS2 für eine Verbindung des Signalausgangsanschlusses 5 mit dem Anschluß 4 des Stromversorgungsabschnittes 11 und des Signalausgangsanschlusses 6 mit dem Anschluß des Stromversorgungsanschlusses oder umgekehrt. Die Zweigimpedanzen Zₛ₁ bis Zₛ₄ können sehr niedrige Werte haben, die nur von den EIN-Widerständen von Halbleiterschaltern, beispielsweise MOSFETs, bestimmt werden, die zum Implementieren der Umschalter TS1 und TS 2 verwendet werden. Falls gewünscht, kann der Wert dieser Zweigimepdanzen Zₛ₁ bis Zₛ₄ vergrößert werden, um für eine Quellimpedanzanpassung der Übertragungsleitung 9 zu sorgen, die mit den Ausgangsanschlüssen 5 und 6 verbunden ist. In diesem Fall ist für eine ordnungsgemäße Quellimpedanzanpassung ein über die Stromversorgungsanschlüsse 3 und 4 geschalteter Kondensator vorteilhaft, wie beispielsweise in Figur 2a gezeigt ist.

Wenn die Zweigimpedanzen eines Zweiges so groß sind wie die jeweiligen Zweigimpedanzen des anderen Zweiges, wird deutlich, daß unabhängig vom logischen Pegel des Eingangssignals Usignal der Verstärkerabschnitt 12-2 als Lastwiderstand R wirkt, der über die Ausgangsanschlüsse 3 und 4 des Stromversorgungsabschnittes 11 geschaltet ist. Der Wert R ist gleich der Summe der über die Signalausgangsanschlüsse 5 und 6 geschalteten Impedanz, der oberen Zweigimpedanz Zₛ₁ oder Zₛ₂ und der unteren Zweigimpedanz Zₛ₃ oder Zₛ₄. Wenn die Zweigimpedanzen Zₛ₁ bis Zₛ₄ Null oder nahezu Null sind, wird die gesamte, von dem Stromversorgungsabschnitt 11 an den Verstärkerabschnitt 12-2 gelieferte Leistung an die Übertragungsleitung 9, die mit den Ausgangsanschlüssen 5 und 6 verbunden ist, ausgegeben. Auf diese Weise kann die Verlustleistung in dem Verstärkerabschnitt 12-2 minimal gehalten werden, und gleichzeitig kann durch geeignetes Einstellen der von dem Stromversorgungsabschnitt 11 über die Anschlüsse 3 und 4 gelieferten Leistung die über die Übertragungsleitung 9 niedriger Impedanz übertragene Leistung durch den Stromversorgungsabschnitt 11 mit hohem Wirkungsgrad und minimaler Verlustleistung kontrolliert werden.

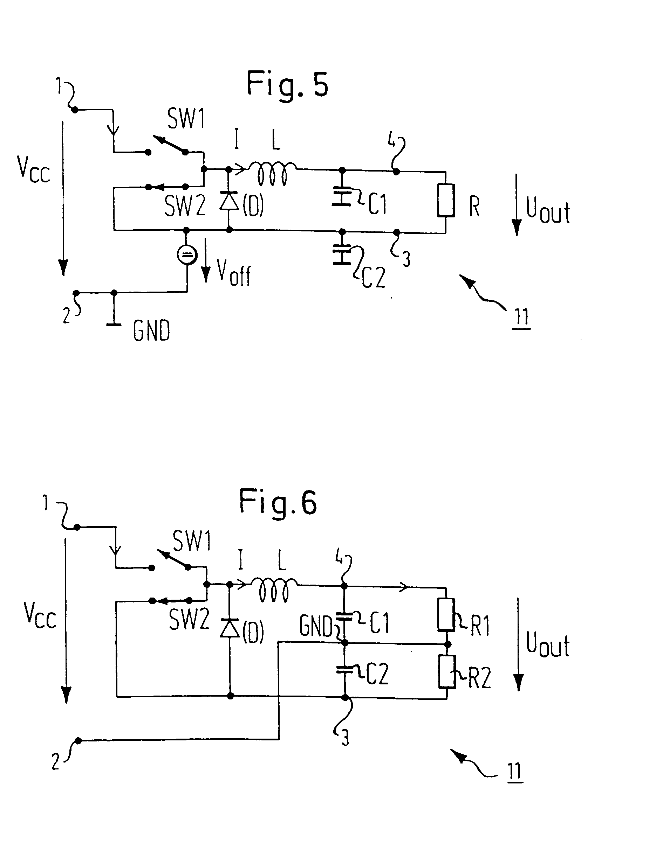

Figur 5 zeigt ein zweites Ausführungsbeispiel eines Stromversorgungsabschnittes 11 eines Ausgangspufferschaltkreises, der zum Übertragen von digitalen Signalen an einen Empfänger nach dem LVDS Standard verwendet werden kann. Gemäß diesem Standard bestimmt der Ausgangspuffer 10 den Gleichtaktpegel V_{C} auf der mit den Signalausgangschlüssen 5 und 6 des Ausgangspuffers 10 verbundenen Übertragungsleitung 9. Der mit den Widerständen RT1 und RT2 in Figur 1 schematisch dargestellte Empfänger stellt den Gleichtaktspannungspegel U_{C} nicht bereit. Mit anderen Worten, schließt der Empfänger für den LVDS Standard die Spannungsquelle U_{C}, die in Figur 1 dargestellt ist, nicht ein. Gemäß diesem Standard erwartet der Empfänger, daß die Spannungen auf den jeweiligen Signalleitungen der Übertragungsleitung 9 innerhalb eines spezifizierten Intervalls sind, wobei alle Spannungswerte innerhalb des spezifizierten Intervalls bezüglich Masse positiv sind.

Der in Figur 5 dargestellte Stromversorgungsabschnitt 11 liefert Leistung an den Verstärkerabschnitt 12-2, der mit den Ausganganschlüssen 3 und 4 des Stromversorgungsabschnittes 11 verbunden ist, und sorgt darüber hinaus für den geeigneten Gleichtaktspannungspegel auf der Übertragungsleitung 9, die mit den Signalausgangsanschlüssen 5 und 6 des Verstärkerabschnittes 12-2 verbunden ist.

Ähnlich dem ersten Ausführungsbeispiel des Stromversorgungsabschnittes 11 umfaßt das zweite Ausführungsbeispiel des Stromversorgungsabschnittes 11 eine Induktivität L, welche als Einrichtung zum zeitweiligen Speichern von Energie dient. Darüber hinaus sind Schalter SW1 und SW₂ zum Steuern des Ladens von Energie von einer (nicht gezeigten) Energiequelle, die mit den Anschlüssen 1 und 2 verbunden ist, in die Induktivität L, und des Entladens der in der Induktivität L gespeicherten Energie in den Verstärkerabschnitt 12-2 vorgesehen, der mit den Anschlüssen 3 und 4 verbunden ist und schematisch durch einen Widerstand R dargestellt ist. Ähnlich dem ersten Ausführungsbeispiel des Stromversorgungsabschnittes 11 ist der Schalter SW1 zwischen die Induktivität L und den Stromversorgungsanschluß 1 geschaltet, welcher eine Versorgungsspannung V_{CC} bereitstellt, und steuert die Ladephase, während der Schalter SW₂ die Entladephase steuert.

In diesem Ausführungsbeispiel ist der Schalter SW2 zwischen einen ersten Anschluß einer Offset-Spannungsquelle V_{off} und denjenigen Anschluß der Induktivität L geschaltet, der mit SW1 verbunden ist. Der zweite Anschluß der Offset-Spannungsquelle V_{off} ist mit dem mit Masse (GND) verbundenen Stromversorgungsanschluß 2 verbunden. Anschluß 4 ist mit dem anderen Ende der Induktivität verbunden, während Anschluß 3 mit dem genannten ersten Anschluß der Offset-Spannungsquelle Voff verbunden ist. Eine Diode D kann über den Schalter SW2 geschaltet sein, um als Freilaufdiode zu wirken, oder kann den Schalter SW2 ersetzen, um selbst als Schalter zu wirken. Ein Kondensator C1 kann zwischen den Stromversorgungsanschluß 4 und Masse geschaltet sein, um die Spannung zwischen Anschluß 4 und Masse zu glätten. In gleicher Weise kann ein Kondensator C2 zwischen Anschluß 3 und Masse geschaltet sein, um die Spannung zwischen Anschluß 3 und Masse zu glätten. Die Kondensatoren C1, C2 und die Diode D sind vorteilhaft, jedoch für den grundlegenden Betrieb dieses Schaltkreises nicht erforderlich. Betreffend die Funktion der optionalen Diode D gelten ähnliche Erwägungen wie für das Ausführungsbeispiel der Figur 2a auch für dieses Ausführungsbeispiel.

Bezugnehmend auf das Zeitdiagramm der Figur 3 ist während der Ladephase A der Schalter SW1 in einem leitenden Zustand, während der Schalter SW2 in einem nicht leitenden Zustand ist. Während dieser Phase tritt die über die Stromversorgungseingangsanschlüsse 1 und 2 geschaltete Versorgungsspannung V_{CC} über der Reihenschaltung der Induktivität L, der Last R und der Offset-Spannungsquelle V_{off} auf, was in einem Strom I resultiert, der von dem Stromversorgungseingangsanschluß 1 durch den Schalter SW1, die Induktivität L zum Ausgangsanschluß 4, durch den Vestärkerabschnitt 12-2, dargestellt durch R, durch den Anschluß 3 und durch die Offset-Spannungsquelle V_{off} zurück zum Stromversorgungseingangsanschluß 2 fließt. In dieser Ladephase A wird die Leistung von der Spannungsquelle an den Anschlüssen 1 und 2 teilweise an die Last R geliefert und teilweise vergrößert sie die in der Induktivität L gespeicherte Energie. Ferner fließt ein Teil der in dieser Phase A gelieferten Leistung in die Offset-Spannungsquelle V_{off}. In einer praktischen Implementierung kann die Offset-spannungsquelle Voff eine Parallelschaltung eines Kondensators C2 und einer Diode sein, deren Anode der genannte erste Anschluß der Offset-Spannungsquelle ist, während die Kathode der zweite Anschluß der Offset-Spannungsquelle ist. Mit dieser Implementierung kann der durch die Diode D fließende Strom I verwendet werden, die Offset-Spannung aufrechtzuerhalten, unter Ausnutzung der Vorwärtsspannung aufgrund des Stromes I. Natürlich kann, falls eine höhere Offset-Spannung erforderlich ist, die Diode durch eine Zenerdiode ersetzt werden, deren Kathode der genannte erste Anschluß der Offset-Spannungsquelle ist, während ihre Anode der zweite Anschluß der Offset-Spannungsquelle ist.

Nach Verstreichen der Zeit ta wechselt der Schalter SW1 in einen nicht leitenden Zustand, um die Ladephase A zu beenden und der Schalter SW2 wechselt in einen leitenden Zustand, um die Entladephase B zu beginnen, in welcher Energie, die in der Induktivität L gespeichert ist, in den mit den Anschlüssen 3 und 4 verbundenen Verstärkerabschnitt 12-2 entladen wird. In dieser Phase fährt der Strom I fort, durch die Induktivität I zu fließen, durch die Last R, welche den Verstärkerabschnitt 12-2 darstellt, und durch die Schalter SW₂ zurück zur Induktivität L. Während dieser Phase entlädt die Induktivität L wenigstens einen Teil der während der Phase A akkumulierten Energie in die Last R und liefert somit Leistung an den Verstärkerabschnitt 12-2. Unter der Annahme idealer Komponenten gibt es in dieser Phase keine Verlustleistung. Solange kein wesentlicher Strompfad von einem oder beiden der Ausgangsanschlüsse 3, 4 nach Masse vorhanden ist, fließt kein wesentlicher Strom durch die Offset-Spannungsquelle V_{off}. Wenn die Offset-Spannungsquelle V_{off} mittels einer Parallelschaltung einer Diode und eines Kondensators C2 implementiert ist, wie oben erläutert, behält der Kondensator C2 die Offset-Spannung V_{off} während der Phase B bei.

Ähnlich dem Ausführungsbeispiel der Figur 2a ermöglicht geeignetes Einstellen des Tastverhältnisses ta/(ta+tb) die Einstellung der in den Verstärkerabschnitt 12-2 fließenden Leistung, ohne daß in dem Stromversorgungsabschnitt 11 nennenswerte Verlustleistung entsteht.

Eine (nicht gezeigte) Modifikation des Ausführungsbeispiels der Figur 5 kann vorteilhaft zur Übertragung von digitalen Signalen an einen Empfänger verwendet werden, der dem DPECL Standard entspricht. Gemäß dieser Modifikation ist Anschluß 1 des Schaltkreises dieser Figur mit Masse verbunden, während Anschluß 2 mit Vcc verbunden ist, die Polarität der Offset-Spannungsquelle Voff umgekehrt ist, und die Diode D, falls vorhanden, umgedreht ist. Dann weist Anschluß 3 ein Potential auf, welches um Voff niedriger ist als Vcc, während Anschluß 4 ein Potential hat, welches um die Spannung über R niedriger ist als das Potential des Anschlusses 3.

Figur 6 zeigt ein drittes Ausführungsbeispiel eines Stromversorgungsabschnittes 11, der verwendet werden kann, digitale Signale an einen Empfänger nach dem GLVDS Standard zu übertragen. Gemäß diesem Standard erwartet der Empfänger, daß die Potentiale der Eingangssignale in einem Fenster liegen, welches das Potential der Masseleitung einschließt. Beispielsweise erwartet der Empfänger bezüglich des Massepotentials symmetrische differentielle Signale. Zu diesem Zweck schließt der GLVDS Empfänger ein Paar von Abschlußwiderständen RT1 und RT2 ein, wobei jeder Widerstand einen Leiter der Übertragungsleitung 9 mit Masse verbindet, wie in Figur 1 gezeigt ist, wenn die in Figur 1 dargestellte Spannungsquelle U_{C} auf Null Volt gesetzt wird, d.h. einen Kurzschluß nach Masse darstellt.

Der in Figur 6 gezeigte Stromversorgungsabschnitt 11 liefert Leistung an den Verstärkerabschnitt 12-2, der mit den Ausgangsanschlüssen 3 und 4 des Stromversorgungsabschnittes 11 verbunden ist, und sorgt darüber hinaus für symmetrische Signalübertragung auf der Übertragungsleitung bezüglich Masse in dem Sinn, daß einer der Leiter der Übertragungsleitungen bezüglich Masse positiv ist, während der andere Leiter der Übertragungsleitung 9 bezüglich Masse negativ ist.

Gemäß diesem Ausführungsbeispiel wird dieses dadurch erreicht, daß eine Versorgungsspannung über den Ausgangsanschlüssen 3 und 4 des Stromversorgungsabschnittes 11 bereit gestellt wird, die wenigstens ungefähr symmetrisch bezüglich Masse ist. Dieses kann so erzielt werden, daß der Stromversorgungsabschnitt 11 derart konstruiert ist, daß eine erste Impedanz R1, welche den Ausgangsanschluß des Stromversorgungsabschnittes 11 mit Masse verbindet, in eine Stromschleife eingeschlossen ist, welche die Reaktanzeinrichtung L während der Ladephase lädt, während eine zweite Impedanz R2, welche den Ausgangsanschluß 3 des Stromversorgungsabschnittes mit Masse verbindet, in eine Stromschleife zum Entladen der Reaktanzeinrichtung L während der Entladephase eingeschlossen ist. Die Impedanzen R1 und R2 können schematische Darstellungen des elektrischen Verhaltens des Verstärkerabschnittes 12-2 im Hinblick auf seine Verbindung mit den Anschlüssen 3 und 4 des Stromversorgungsabschnittes 11 sein.

Spezifisch umfaßt das dritte Ausführungsbeispiel des Stromversorgungsabschnittes 11 ähnlich dem ersten und zweiten Ausführungsbeispiel des Stromversorgungsabschnittes 11 eine Induktivität L, welche als Einrichtung zum zeitweiligen Speichern von Energie dient. Ferner sind Schalter SW1 und SW2 zum Steuern des Ladens von Energie von einer (nicht gezeigten) Spannungsquelle, die mit den Anschlüssen 1 und 2 verbunden ist, in die Induktivität L vorgesehen, und zum Entladen der in der Induktivität L gespeicherten Energie in den Verstärkerabschnitt 12-2, der mit den Anschlüssen 3 und 4 verbunden ist und schematisch durch Widerstände R1 und R2 dargestellt ist, die jeweils mit einem der Ausgangsanschlüsse 3 und 4 des Stromversorgungsabschnittes 11 verbunden sind. Beide Widerstände sind mit dem geerdeten Eingangsanschluß 2 des Stromversorgungsabschnittes 11 verbunden. Der Schalter SW1 ist zwischen die Induktivität L und den Stromversorgungsanschluß 1 geschaltet, welcher eine Versorgungsspannung V_{CC} bezüglich des Stromversorgungsanschlusses 2 bereitstellt, und steuert die Ladephase. Der andere Anschluß der Induktivität L ist mit dem Ausgangsanschluß 4 des Stromversorgungsabschnittes 11 verbunden.

Der Schalter SW2 ist zwischen den Ausgangsanschluß 3 des Stromversorgungsabschnittes 11 und denjenigen Anschluß der Induktivität L geschaltet, der mit SW1 verbunden ist. Eine Diode D kann über den Schalter SW2 geschaltet sein, um als Freilaufdiode zu dienen, oder kann.den Schalter SW2 ersetzen, um selbst als Schalter zu wirken. Ein Kondensator C1 kann zwischen den Ausgangsanschluß 4 und Masse geschaltet sein, um die Spannung zwischen Anschluß 4 und Masse zu glätten. In gleicher Weise kann ein Kondensator C2 zwischen den Anschluß 3 und Masse geschaltet sein, um die Spannung zwischen Anschluß 3 und Masse zu glätten. Die Kondensatoren C1, C2 und die Diode D sind vorteilhaft, jedoch nicht notwendig für den grundlegenden Betrieb dieses Schaltkreises. Betreffend die Funktion der optionalen Diode D sind ähnliche Erwägungen wie im Ausführungsbeispiel der Fig. 2a ebenfalls für dieses Ausführungsbeispiel gültig.

Bezugnehmend auf das Zeitdiagramm der Figur 3 ist der Schalter SW1 während der Ladephase A in leitendem Zustand, während der Schalter SW2 in einem nichtleitenden Zustand ist. Während dieser Phase tritt die über die Stromversorgungseingangsanschlüsse 1 und 2 angelegte Versorgungsspannung V_{CC} über der Reihenschaltung der Induktivität L und der Impedanz R1 auf, was in einem Strom I resultiert, der von dem Stromversorgungseingangsanschluß 1 durch den Schalter SW1, die Induktivität L, zum Ausgangsanschluß 4, durch R1, welcher einen Teil des Verstärkerabschnittes 12-2 darstellt, nach Masse fließt, die mit dem Stromversorgungseingangsanschluß 2 verbunden ist. In dieser Ladephase A wird die Leistung von der Spannungsquelle an den Anschlüssen 1 und 2 teilweise an die Lastimpedanz R1 geliefert, und teilweise erhöht sie die in der Induktivität L gespeicherte Energie. Ein Spannungsabfall, welcher während dieser Phase über der Lastimpedanz R1 auftritt, führt dazu, daß der Ausgangsanschluß 4 bezüglich des mit Masse verbundenen Ausgangsanschlusses 2 positiv ist.

Nach Verstreichen der Zeit ta wechselt der Schalter SW1 in einen nichtleitenden Zustand, um die Ladephase A zu beenden, und der Schalter SW2 wechselt in einen leitenden Zustand, um die Entladephase B zu beginnen, in welcher Energie, die in der Induktivität L gespeichert ist, in den Verstärkerabschnitt 12-2 entladen wird, der mit den Anschlüssen 3 und 4 verbunden ist. In dieser Phase fährt der Strom I fort, durch die Induktivität L zu fließen, durch die Lastimpedanzen R1 und R2, welche den Verstärkerabschnitt 12-2 darstellen, und durch den Schalter SW2 zurück zur Induktivität L. Während dieser Phase entlädt die Induktivität L wenigstens einen Teil der während der Phase A akkumulierten Energie in die Lastimpedanzen R1 und R2 und liefert somit Leistung an den Verstärkerabschnitt 12-2. Ein Spannungsabfall während dieser Entladephase B über der Lastimpedanz R1 erhält positives Potential am Anschluß 4 bezüglich Masse. Ein während dieser Phase über der Lastimpedanz R2 auftretender Spannungabfall führt dazu, daß der Ausgangsanschluß 3 bezüglich des mit Masse verbundenen Anschlusses 2 negativ ist. Der Kondensator 2 ist zum Beibehalten der negativen Spannung am Anschluß 3 während der folgenden Ladephase A besonders vorteilhaft.

Unter Annahme idealer Komponenten ist sowohl in der Ladephase A als auch in der Entladephase B keine Verlustleistung in dem Stromversorgungsabschnitt 11 des Ausführungsbeispiels vorhanden. Ähnlich dem Ausführungsbeispiel der Figur 2a ermögijch die geeignete Einstellung des Tastverhältnisses ta/(ta+tb), daß die in den Vestärkerabschnitt 12-2 hineinfließende Leistung eingestellt wird, ohne daß nennenswerte Leistung in dem Stromversorgungsabschnitt 11 verloren geht.

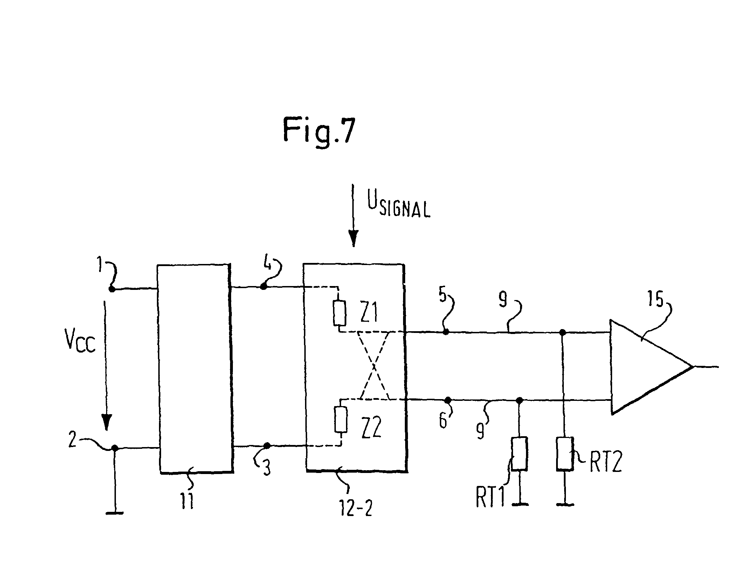

Figur 7 zeigt ein Blockdiagramm zum Erläutern der Verbindungen zwischen dem Stromversorgungsabschnitt 11 gemäß einem der Ausführungsbeispiele oder ihrer Modifikationen, die in dieser Beschreibung offenbart sind, dem beispielsweise in Figur 4 gezeigten Verstärkerabschnitt 12-2, und einer Übertragungsleitung 9 zu einem Empfänger. Die Figur zeigt das GLVDS Beispiel, daß eine Abschlußimpedanz RT1 einen Leiter der Übertragungsleitung 9 mit Masse verbindet, und die Abschlußimpedanz RT2 den anderen Leiter der Übertragungsleitung 9 mit Masse verbindet. Die gestrichelten Linien in dem Verstärkerabschnitt 12-2 einschließlich der Impedanzen Z1 und Z2 stellen die Schaltungsteile dar, die detaillierter unter Bezugnahme auf Figur 4 erläutert sind, unter der Annahme, daß Zₛ₁ gleich Zₛ₂ gleich Z1 und Zₛ₃ gleich Zₛ₄ gleich Z2, d.h. unter der Annahme einer Symmetrie des Verstärkerabschnittes 12-2. Die sich kreuzenden gestrichelten Linien in Bock 12-2 bedeuten, daß abhängig vom logischen Pegel des Eingangssignals U_{Signal}, der Anschluß 4 mit Anschluß 5 über die Impedanz Z1 verbunden ist, und Anschluß 3 über die Impedanz Z2 mit Anschluß 6 verbunden ist, oder der Anschluß 4 über die Impedanz Z1 mit Anschluß 6 verbunden ist, und der Anschluß 3 über die Impedanz Z2 mit Anschluß 5 verbunden ist. Der Empfängerverstärker 15 erfaßt die differentiellen Signale am empfängerseitigen Ende der Übertragungsleitung 9 und wandelt diese Signale in geeignete Logikpegel um, die zur weiteren Verarbeitung von der Schaltung, die von dem Empfängerverstärker 15 angesteuert wird, geeignet sind. Dieser Verstärker kann irgend eine geeignete Art von differentiellen Verstärker sein, dessen Auswahl für die vorliegende Erfindung nicht signifikant ist.

Für den speziellen Fall von GLVDS ist aus dem schematischen Blockdiagramm der Figur 7 ersichtlich, daß unter der Annahme Z1 = Z2 und RT1 = RT2, die Verbindung des Verstärkerabschnittes 12-2 mit den Ausgangsanschlüssen 4 und 3 des Stromversorgungsabschnittes 11, die Verbindung der Übertragungsleitung 9 mit den Signalausgangsanschlüssen 5 und 6 des Verstärkerabschnittes 12-2 und die Schaltung von Abschlußimpedanzen RT1 und RT2 zwischen jeweilige Leiter der Übertragungsleitung 9 und Masse äquivalent dem Schalten einer ersten Lastimpedanz R1 zwischen den Ausgangsanschluß 4 des Stromversorgungsabschnittes 11 und Masse und einer zweiten Lastimpedanz R2 zwischen Ausgangsanschluß 3 des Stromversorgungsabschnittes 11 und Masse ist, wobei der Wert von R1 bzw. R2 die Summe von Z1 und RT1 ist, wie schematisch in Figur 6 dargestellt ist. Ferner ist aus dieser Figur allgemein ersichtlich, daß gemäß der vorliegenden Erfindung die Lastimpedanz über den Anschlüssen 3 und 4 des Stromversorgungsabschnittes 11 von dem Verstärkerabschnitt 12-2 gebildet wird, an dessen Ausgangsanschlüssen 5 und 6 die Übertragungsleitung 9 angeschlossen ist. Wenn der Verstärkerabschnitt 12-2 im obigen Sinn symmetrisch vorgesehen ist, kann die Lastimpedanz darüber hinaus unabhängig vom Schaltzustand des Verstärkerabschnittes 12-2 sein.

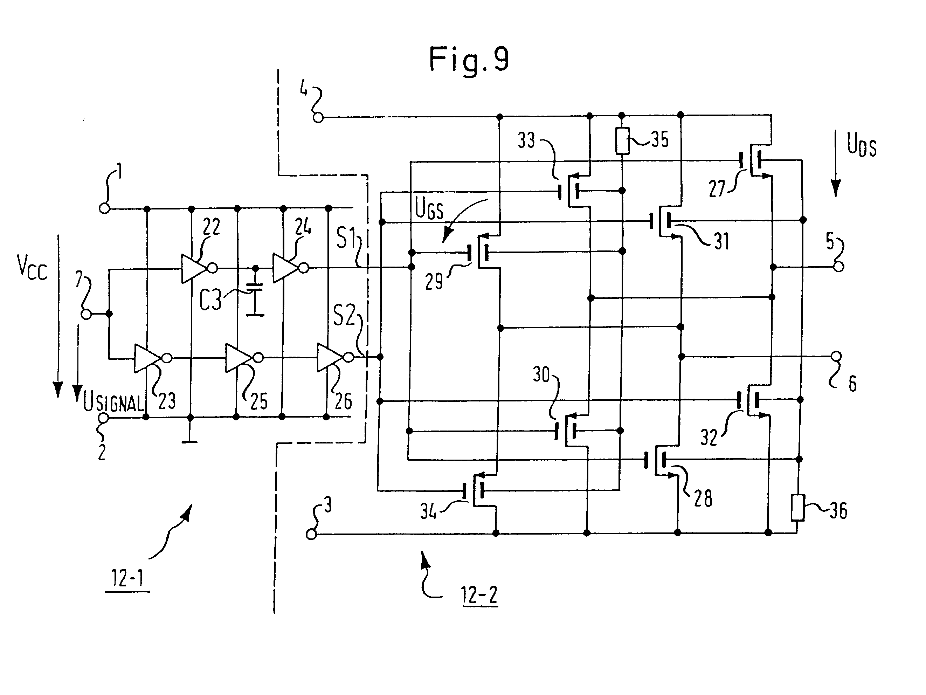

Figur 8 zeigt ein viertes Ausführungsbeispiel des Stromversorgungsabschnittes 11 gemäß der vorliegenden Erfindung. Dieses Ausführungsbeispiel des Stromversorgungsabschnittes 11 stellt über den Ausgangsanschlüssen 4 und 3 eine Ausgangsspannung Uₒᵤₜ bereit, welche bezüglich einer über den Eingangsanschlüssen 1 und 2 des Stromversorgungsabschnittes 11 angelegten Eingangsspannung V_{CC} "schwimmt". "Schwimmen" bedeutet hier, daß das Potential von irgendeines der Ausgangsanschlüsse 3 und 4 bezüglich irgendeinem der Eingangsanschlüsse 1 und 2 undefiniert ist. Wenn eine Spannung innerhalb vernüftiger Grenzen über einen der Eingangsanschlüsse 1 und 2 und einen der Ausgangsanschlüsse 3 und 4 angelegt wird, führt diese Spannung nicht zu einem nennenswerten Stromfluß zwischen der Eingangsseite und der Ausgangsseite. Ferner beeinflußt solch eine Spannung nicht den Betrieb dieses Ausführungsbeispiels des Stromversorgungsabschnittes 11.

Für diesen Zweck, die Ausgangsspannung "schwimmend" vorzusehen, schließt dieses Ausführungsbeispiel ein erstes Paar von Schaltern SW1a, SW1b und ein zweites Paar von Schaltern SW2a, SW2b ein. SW1a und SW2b sind in Reihe geschaltet, wobei diese Reihensschaltung zwischen einen Anschluß 1 der Eingangsanschlüsse und einen Anschluß 3 der Ausgangsanschlüsse geschaltet ist. SW1b und SW2a sind in Reihe geschaltet, wobei diese Reihenschaltung zwischen den anderen Anschluß 2 der Eingangsanschlüsse und den anderen Anschluß 4 der Ausgangsanschlüsse geschaltet ist. Bezugsziffer 110 bezeichnet einen Verbindungspunkt zwischen dem Schalter SWla und dem Schalter SW2b während Bezugszeichen 22 einen Verbindungspunkt zwischen dem Schalter SWlb und dem Schalter SW2a bezeichnet. Eine Induktivität L ist zwischen den verbindungspunkt 110 und den Verbindungspunkt 22 geschaltet. R stellt schematisch eine Lastimpedanz dar, die durch den Verstärkerabschnitt 12-2 gebildet wird, der mit den Ausgangsanschlüssen 3 und 4 des Stromversorgungsabschnittes 11 verbunden ist. C bezeichnet einen Kondensator, der über die Ausgangsanschlüsse 3 und 4 geschaltet werden kann, um die Ausgangsspannung Uout über den Anschlüssen 3 und 4 zu glätten. Zusätzlich dazu oder alternativ können (nicht gezeigte) Kondensatoren zwischen jedem der Ausgangsanschlüsse 3, 4 und Masse vorgesehen sein. D1 und D2 bezeichnen Freilaufdioden, welche jeweils über die Schalter SW2a und SW2b geschaltet sein können.

In diesem Ausführungsbeispiel ist das erste Paar von Schaltern SWla, SWlb zum Steuern des Ladens von Energie von einer (nicht gezeigten) Spannungsquelle, die mit den Anschlüssen 1 und 2 verbunden ist, in die Induktivität L vorgesehen. Das zweite Paar von Schaltern ist vorgesehen, um die in der Induktivität gespeicherte Energie in den Verstärkerabschnitt 12-2 zu entladen, der schematisch durch eine Impedanz R dargestellt ist. Bezugnehmend auf das Zeitdiagramm der Figur 3 sind während der Ladephase A die Schalter SW1a und SW1b in einem leitenden Zustand, während die Schalter SW2a und SW2b in einem nicht leitenden Zustand sind. Während dieser Phase tritt die über die Stromversorgungseingangsanschlüsse 1 und 2 geschaltete Versorgungsspannung V_{CC} über der Induktivität L auf, was in einem Anwachsen der in der als Reaktanzeinrichtung wirkenden Induktivität L gespeicherten Energie resultiert. Unter der Annahme idealer Komponenten gibt es in dieser Phase A keine Verlustleistung.

Nach Ablauf der Zeit ta wechseln die Schalter SW1 und SW1b in einen nicht leitenden Zustand, um die Ladephase A zu beenden und die Schalter SW2a und SW2b wechseln in einen leitenden Zustand, um die Entladephase B zu beginnen, in welcher in der Induktivität L gespeicherte Energie in die Anschlüsse 3 und 4 des Stromversorgungsabschnittes 11 entladen wird. Um die Ausgangsspannung über den Ausgangsanschlüssen 3, 4 während der folgenden Ladephase A beizubehalten, ist es besonders vorteilhaft, über die Ausgangsanschlüsse 3 und 4 einen Kondensator 10 zu schalten.

Mit dieser Konstellation der Schalter SW1a, SW1b und SW2a, SW2b ist es möglich, alle Eingangsanschlüsse 1, 2 fortwährend von allen Ausgangsanschlüssen 3, 4 getrennt zu halten, während der Energietransfer von den Eingangsanschlüssen zu den Ausgangsanschlüssen gesteuert wird. Während der Ladephase A sind nämlich die Schalter SWla und SWlb leitend, jedoch sind die Schalter SW2a und SW2b nicht leitend, so daß durch die zwei Paare von Schaltern und die Reaktanzeinrichtung keine elektrische Verbindung zwischen irgendeinem der Eingangsanschlüsse 1, 2 und irgendeinem der Ausgangsanschlüsse 3, 4 existiert. Dasselbe gilt für die Entladephase, in welcher die Schalter SWla und SWlb nicht leitend sind, während die Schalter SW2a und SW2b in einem leitenden Zustand sind. Aufgrund dieser fortwährenden Trennung der Eingangsanschlüsse 1, 2 von den Ausgangsanschlüssen 3, 4 tritt eine schwimmende Ausgangsspannung über den Ausgangsanschlüssen 3, 4 auf, d.h. eine Ausgangsspannung ohne vorbestimmte Referenz zu dem Potential der Eingangsanschlüsse 1, 2.

Um einen Kurzschluß zwischen den Stromversorgungsanschlüssen 1 und 2 und den Ausgangsanschlüssen 3 und 4 des Stromversorgungsabschnittes 11 zu vermeiden, überlappen sich die leitenden Zustände des ersten Paares von Schaltern SWla, SW1b und des zweiten Paares von Schaltern SW2a, SW2b bevorzugt zeitlich nicht. Dieses kann zu einer zeitlichen Überlappung der nichtleitenden Zustände beider Paare von Schaltern führen. In dieser Situation können Freilaufdioden D1 und D2, die über den Schalter SW2a bzw. SW2b geschaltet sind, den Schaltkreis für den Strom schließen, der während der Entladephase B von der Induktivität L erzwungen wird. Wenn die Verlustleistung in diesen Freilaufdioden tolerierbar ist, kann das zweite Paar von Schaltern SW2a, SW2b ausgelassen werden.

Unter der Annahme idealer Komponenten tritt in dem Stromversorgungsabschnitt 11 dieses Ausführungsbeispiels sowohl in der Ladephase A als auch in der Entladephase B keine Verlustleistung auf.

Ähnlich dem Ausführungsbeispiel der Fig. 2a ermöglicht die geeignete Einstellung des Tastverhältnisses Ta/(Ta+Tb) die Einstellung der in den Verstärkerabschnitt 12-2 hineinfließenden Leistung, ohne daß nennenswerte Leistung in dem Stromversorgungsabschnitt 11 verlorengeht.

Dieses Ausführungsbeispiel ist insbesondere vorteilhaft darin, daß der Verstärkerabschnitt 12-2, der die Übertragungsleitung 9, wie beispielsweise in Fig. 1 gezeigt, ansteuert, bezüglich des Potentials der Stromversorgungsanschlüsse 1 und 2 schwimmend gehalten werden kann, so daß ebenfalls das Potential auf jedem der Signalleiter der Übertragungsleitung 9 bezüglich der Eingangsanschlüsse 1 und 2 schwimmend ist. Dieses Merkmal ermöglicht, daß der Ausgangspufferschaltkreis gemäß dem vierten Ausführungsbeispiel ohne Pegelumwandlung mit Eingangsschaltkreisen zusammenarbeiten kann, welche verschiedene Signalübertragungsstandards verwenden. Mit anderen Worten ist ein Ausgangspufferschaltkreis einschließlich eines Stromversorgungsabschnittes 11 gemäß dem vierten Ausführungsbeispiel völlig flexibel im Hinblick auf vom Empfänger bestimmte Gleichtaktspannungspegel auf der Übertragungsleitung 9. Insbesondere ist dieser Ausgangspufferschaltkreis in der Lage, alle möglichen Alternativen betreffend den Abschluß der in Fig. 1 gezeigten Übertragungsleitung 9 anzusteuern. Der Ausgangspuffer arbeitet ordnungsgemäß, wenn die in Fig. 1 gezeigte Gleichtaktspannung U_{C} beliebige positive oder negative Werte innerhalb vernünftiger Grenzen annimmt, und ist demgemäß geeignet, LVDS, GLVDS, DPECL und andere, ähnliche Typen von Emfängern anzusteuern. Ferner arbeitet der Ausgangspufferschaltkreis gemäß diesem Ausführungsbeispiel ordnungsgemäß mit Empfängern zusammen, welche anstelle der Spannungsquelle U_{C} in Fig. 1 einen der Leiter der Übertragungsleitung 9 mit einem vorbestimmten, prinzipiell beliebigen Potential verbinden. Der Ausgangspuffer arbeitet desweiteren ordnungsgemäß mit einem Empfänger zusammen, der schwimmende differenzielle Eingänge aufweist, entsprechend dem Fall, daß die Spannungsquelle U_{C} überhaupt nicht vorhanden ist. Eine (nicht gezeigte) Spannungsquelle kann zwischen einem der Eingangsanschlüsse 1 und 2 und einem der Ausgangsanschlüsse 3 und 4 vorgesehen sein, um den Ausgangspuffer in die Lage zu versetzen, den Gleichtaktspannungspegel auf der Übertragungsleitung 9 zu bestimmen. Diese Spannungsquelle kann bevorzugt programmierbar und/oder abschaltbar sein, um die von dem Stromversorgungsabschnitt 11 gemäß dem vierten Ausführungsbeispiel gebotene Flexibilität voll auszunutzen.

Fig. 9 zeigt ein Ausführungsbeispiel eines Pufferverstärkerabschnittes 12 einschließlich eines Vorverstärkerabschnittes 12-1 und eines Verstärkerabschnittes 12-2, welcher Pufferverstärkerabschnitt 12 besonders vorteilhaft in Kombination mit dem Stromversorgungsabschnitt 11 gemäß dem vierten, in Fig. 8 gezeigten Ausführungsbeispiel ist, jedoch mit irgendeinem der zuvor beschriebenen Ausführungsbeispiele des Stromversorgungsabschnittes zusammenarbeiten kann.

Der Vorverstärkerabschnitt 12-1 und der Verstärkerabschnitt 12-2 des Pufferverstärkerabschnittes 12 sind miteinander über ein Paar von komplementären Signalleitungen S1 und S2 verbunden. Das differenzielle Potential auf diesen Leitungen hängt von dem logischen Pegel eines Eingangssignals U_{Signal} ab, das zwischen einen Signaleingangsanschluß 7 des Vorverstärkerabschnittes 12-1 und Masseanschluß 2 des Vorverstärkerabschnittes 12-1 angelegt wird. Die Anschlüsse 1 und 2 sind Stromversorgungsanschlüsse zur Verbindung mit einer (nicht gezeigten) Spannungsquelle V_{CC}.

Der Verstärkerabschnitt 12-2 umfaßt Stromversorgungsanschlüsse 3 und 4 in Verbindung mit dem Ausgang des Stromversorgungsabschnitts 11, beispielsweise gemäß dem vierten Ausführungsbeispiel. Der Verstärkerabschnitt 12-2 umfaßt ferner Signalausgangsanschlüsse 5 und 6 zur Verbindung mit der Übertragungsleitung 9 zum Empfänger.

Wie prinzipiell in Figur 4 gezeigt, umfaßt der Verstärkerabschnitt 12-2 der Figur 8 zwei Umschalter TS1, TS2, jeweils als ein Paar von Schalter ausgeführt, wobei das erste Paar von Schaltern zum Signalausganganschluß 5 gehört, während das zweite Paar von Schaltern zum Signalausgangsanschluß 6 gehört. Die Schalter des Verstärkerabschnittes 12-2 werden Signalschalter genannt, wenn eine Verwechslung mit Schaltern des Stromversorgungsabschnittes 11 auftreten kann. Die Schalter des ersten Paares sind in Reihe zwischen die Stromversorgungsanschlüsse 3 und 4 des Verstärkerabschnittes 12-2 geschaltet. Der Verbindungspunkt zwischen den Schaltern dieses Paares ist mit dem Signalausgangsanschluß 5 verbunden. Die Schalter des zweiten Paares sind in Reihe zwischen die Stromversorgungsanschlüsse 3 und 4 des Verstärkerabschnittes 12-2 geschaltet, wobei der Verbindungspunkt zwischen den Schaltern mit dem Signalausgangsanschluß 6 verbunden ist.

Gemäß diesem Ausführungsbeispiel umfaßt jeder der Schalter einen n-Kanal MOSFET und einen p-Kanal MOSFET, deren Kanäle parallel geschaltet sind. Insbesondere umfaßt in Figur 9 der erste Schalter des ersten Paares von Schaltern, der zwischen den Signalausgangsanschluß 5 und den Stromversorgungsanschluß 4 geschaltet ist, den n-Kanal MOSFET 27 und den p-Kanal MOSFET 33. Der zweite Schalter, der zwischen den Signalausgangsanschluß und den Stromversorgungsanschluß 3 geschaltet ist, umfaßt den n-Kanal MOSFET 32 und den p-Kanal MOSFET 30. Der erste Schalter des zweiten Paares von Schaltern umfaßt den n-Kanal MOSFET 31 und den p-Kanal MOSFET 29 und ist zwischen den Stromversorgungsanschluß 4 und den Signalausgangsanschluß 6 geschaltet. Der zweite Schalter des zweiten Paares umfaßt den n-Kanal MOSFET 28 und den p-Kanal MOSFET 34 und ist zwischen den Signalausgangsanschluß 6 und den stromversorgungsanschluß 3 geschaltet. Die Gates des n-Kanal MOSFET Transistors und des p-Kanal MOSFET Transistors eines jeden Schalters empfangen komplementäre Eingangssignale. Mit anderen Worten sind die Gates des n-Kanal MOSFET Transistors und des p-Kanal MOSFET Transistors eines jeden Schalters mit den komplementären Signalleitungen S1 und S2 so verbunden, daß wenn das Gate des n-Kanal MOSFET Transistors auf hohem Pegel ist, das Gate des p-Kanal MOSFET Transistors auf niedrigem Pegel ist. Ferner ist die Verbindung zwischen den acht Gates der acht MOSFETs mit den komplementären Signalleitungen S1 und S2 von dem Vorverstärkerabschnitt 12-1 derart, daß der Schalter, der einen der Signalausgangsanschlüsse 5, 6 mit dem Stromversorgungsanschluß 4 verbindet, und der Schalter, der den anderen der Signalausgangsanschlüsse 5, 6 mit dem Stromversorgungsanschluß 3 verbindet, denselben Leitfähigkeitszustand haben, und die verbleibenden zwei Schalter den anderen Leitfähigkeitszustand haben, das heißt, leitend oder nicht leitend. Nur ein Schalter eines jeden Paares von Schaltern ist leitend, während der andere nicht leitend ist. Spezifisch ist gemäß dem Ausführungsbeispiel der Figur 9 die Signalleitung S1 mit den Gates der Transistoren 27, 28, und 30 verbunden, während die Signalleitung S2 mit den Gates der Transistoren 31, 32, 33 und 34 verbunden ist.

Die in Figur 4 gezeigten Impedanzen Z_{S1} bis Z_{S4} repräsentieren die EIN - Widerstände der jeweiligen Schalter in Figur 9.

Aufgrund der Tatsache, daß gemäß diesem Ausführungsbeispiel jeder der vier Schalter einen n-Kanal MOSFET Transistor und einen p-Kanal MOSFET Transistor umfaßt, kann der Gleichtaktbetriebsbereich des Verstärkerabschnittes 12-2 wesentlich vergrößert werden. Insbesondere ist es wünschenswert, daß der Verstärkerabschnitt 12-2 selbst dann ordnungsgemäß arbeitet, wenn Potentialdifferenzen zwischen den Anschlüssen 2 und 3 und/oder zwischen den Anschlüssen 1 und 4 auftreten. Solche Potentialdifferenzen treten abhängig davon auf, ob ein von dem Empfänger bestimmter Gleichtaktpegel auf der Übertragungsleitung 9 bezüglich Massepotential vorhanden ist, das heißt, abhängig davon, ob die Spannungsquelle U_{C} in Figur 1 vorhanden ist oder nicht.

Wenn nur die n-Kanal MOSFET Transistoren in jedem der vier Schalter vorhanden wären, würde eine anwachsende Potentialdifferenz zwischen Anschluß 3 und Anschluß 2, die das Potential des Anschlusses 3 über das Potential des Anschlusses 2 hebt, irgendwann dazu führen, daß die Spannung auf den Signalleitungen S1 oder S2 nicht länger ausreichend ist, die n-Kanal MOSFETs einzuschalten. Jedoch wird aufgrund der Gegenwart der p-Kanal MOSFETs der ordnungsgemäße Betrieb des Verstärkerabschnittes 12-2 fortgesetzt, weil dann die Schaltfunktion von den p-Kanal MOSFETs übernommen wird. Mit anwachsendem Potential des Anschlusses 3 bezüglich Anschluß 2 kann der ordnungsgemäße Betreieb solange fortgesetzt werden, bis diese Potentialdifferenz so groß ist, daß die p-Kanal MOSFETs nicht mehr ordnungsgemäß abschalten können.

Demgemäß sorgen die p-Kanal MOSFETs parallel zu den n-Kanal MOSFETS in jedem der vier Schalter des Verstärkerabschnittes 12-2 für eine Ausdehnung des Gleichtaktbetriebsbereichs des Verstärkerabschnittes 12-2. Wenn der Gleichtaktspannungspegel auf der Übertragungsleitung, in Figur 1 durch Uc dargestellt, für die n-Kanal MOSFETs im Verstärkerabschnitt 12-2 zum ordnungsgemäßen Funktionieren zu hoch wird, übernehmen die p-Kanal MOSFETs parallel zu jedem der n-Kanal MOSFETs den Schaltbetrieb und erstrecken somit den Gleichtaktspannungsbereich 9 auf der Übertragungsleitung, den der Ausgangspuffer 10 handhaben kann.

Wenn der Verstärkerabschnitt 12-2 mit einem im wesentlichen invariablen Gleichtaktspannungspegel auf der Übertragungsleitung 9 arbeitet, können natürlich abhängig vom Pegel der Gleichtaktspannung entweder die p-Kanal MOSEFTs oder die n-Kanal MOSFETs ausgelassen werden. Insbesondere können die n-Kanal MOSFETs ausgelassen werden, wenn der Verstärkerabschnitt 12-2 mit einem Stromversorgungsabschnitt der Figur 2b oder Figur 2c zusammen arbeitet. Wenn der Verstärkerabschnitt mit einem Stromversorgungsabschnitt der Figur 2a oder Figur 6 zusammen arbeitet, können die p-Kanal MOSEFTs ausgelassen werden.

Der Vorverstärkerabschnitt 12-1 der Figur 9 ist optional und dient dazu, ein unbalanciertes Eingangssignal, das zwischen dem Signaleingangsanschluß 7 und dem Stromversorgungsanschluß 2 angelegt wird, in ein differentielles Signal auf den Signalleitungen S1 und S2 umzuwandeln, um den Verstärkerabschnitt 12-2 differentiell anzusteuern, so daß eine der Signalleitungen S1, S2 niedrige Spannung hat, während die andere Siganlleitung bezüglich Anschluß 2 auf hohem Spannungspegel ist.

Um eine ordnungsgemäße Phasenbeziehung zwischen den Signalen S1 und S2 sicherzustellen, kann der Vorverstärkerabschnitt 12-1 eine erste Kette von Invertern 22, 24 einschließen, die dem Zweck dienen, das Signal vom Abschluß 7 zur Signalleitung S1 zu verzögern, sowie eine zweite Kette von Invertern 23, 25 und 26 zum Invertieren des Eingangssignals am Anschluß 7 des Vorverstärkerabschnittes 12-1. Um ungefähr gleiche Verzögerungszeiten in beiden Inverterketten zu erreichen, kann es vorteilhaft sein, einen Kondensator C3 zwischen den Eingang des Inverters 24 und Masse zu schalten.

Die gestrichelte Linie in Figur 9 dient dem Zweck, darzustellen, daß der Verstärkerabschnitt 12-2 bezüglich des Vorverstärkerabschnittes 12-1 schwimmend konstriert ist. Zwischen dem Vorverstärkerabschnitt 12-1 und dem Verstärkerabschnitt 12-2 ist keine weitere Verbindung erforderlich als das Paar von differentiellen Signalleitungen S1 und S2.

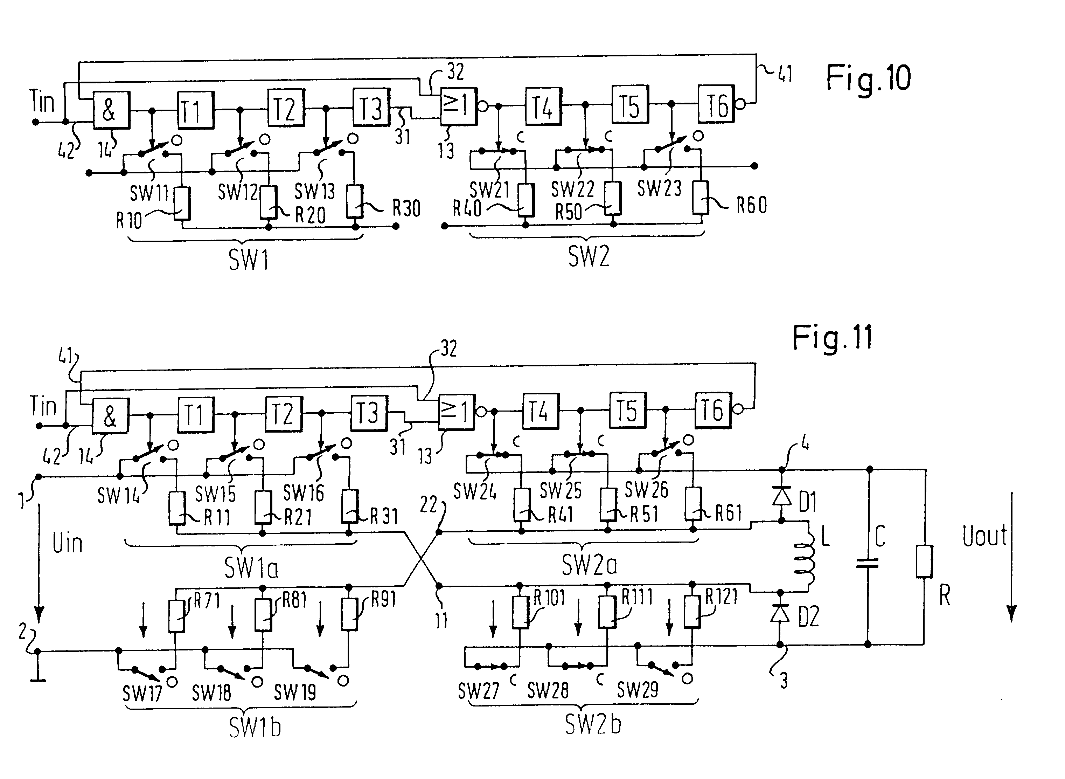

Figur 10 zeigt ein spezifisches Ausführungsbeispiel von Steuereinrichtungen zum Steuern des Schaltzustandes der Schalter SW1 und SW2 des Stromversorgungsabschnittes 11 gemäß einem der ersten bis dritten Ausführungsbeispiele oder ihrer Modifikationen. Diese Figur zeigt die Verbindungen zwischen den Schaltern und anderen Teilen des Stromversorgungsabschnittes nicht, um Wiederholungen zu vermeiden.

Gemäß dem Ausführungsbeispiel der in Figur 10 gezeigten Steuereinrichtungen umfaßt jeder der Schalter SW1, SW2 eine Vielzahl von Halbleiterschaltern. Alle Halbleiterschalter eines jeden Schalters sind parallel geschaltet. In Figur 10 umfaßt der Schalter SW1 drei Schalter SW11, SW12 und SW13, die zueinander parallel geschaltet sind, während der Schalter SW₂ die Halbleiterschalter SW21, SW22 und SW23 umfaßt. Die Impedanzen R10 bis R30 vom SW1 und R40 bis R60 von SW2 bezeichnen die jeweiligen EIN Impedanzen des jeweiligen Halbleiterschalters.

Zum Steuern des Schaltzustandes eines jeden Halbleiterschalters ist für jeden der Schalter SW1 und SW2 eine Kette von Verzögerungsschaltungen zum Verzögern eines Steuersignals vorgesehen. In Figur 10 umfaßt die Kette von Verzögerungsschaltkreisen für den Schalter SW1 die Verzögerungselemente T1 und T2, wobei der Ausgang des Verzögerungselementes T1 mit dem Eingang des Verzögerungselementes T2 verbunden ist. Die Verzögerungselemente T1, T2 steuern den Schaltzustand der Halbleiterschalter SW11 bis SW13 so, daß diese Elemente nicht gleichzeitig, sondern hintereinander ihren Schaltzustand wechseln, was darin resultiert, daß der Schalter SW1 seinen Leitungszustand graduell von nicht leitend nach leitend oder von leitend nach nicht leitend wechselt. Zu diesem Zweck wird ein an den steueranschluß des Schalter SW11 angelegtes Steuersignal von dem Verzögerungselement T1 verzögert, und das verzögerte Steuersignal wird an den Steueranschluß des Schalters SW12 gelegt. Dieses verzögerte Steuersignal wird an das Verzögerungselement T2 gelegt, dadurch einer weiteren Verzögerung unterworfen und dann an den Steueranschluß von Schalter SW13 angelegt.

Entsprechendes gilt für den Schalter SW2, welcher die Halbleiterschalter SW21 bis SW23 umfaßt, deren jeweilige EIN-Widerstände durch die Impedanzen R40 bis R60 dargestellt sind. Die Halbleiterschalter von SW2 werden von einer zweiten Kette von Verzögerungsschaltkreisen T4, T5 angesteuert. Die Funktion und der Betrieb der zweiten Kette von Verzögerungselementen T4, T5 und der Halbleiterschalter SW21 bis SW23 des zweiten Schalters SW2 sind identisch mit den entsprechenden Komponenten des Schalters SW1.

Der Eingang der ersten Kette von Verzögerungselementen T1, T2, das heißt, der Eingang des Verzögerungselementes Tl, ist mit dem Ausgang eines UND Gatters 14 mit zwei Eingängen verbunden. Der Ausgang der ersten Kette von Verzögerungselementen Tl, T2, das heißt, der Ausgang des Verzögerungselementes T2, ist mit dem Eingang eines weiteren Verzögerungselementes T3 verbunden, dessen Ausgang mit einem Eingang 31 eines NOR Gatters 13 mit zwei Eingängen verbunden ist. Der Ausgang des NOR Gatters 13 ist mit dem Eingang der zweiten Kette von Verzögerungselementen verbunden, das heißt, mit dem Eingang des Verzögerungselementes T4. Der Ausgang der zweiten Kette von Verzögerungselementen, das heißt, der Ausgang des Verzögerungselementes T5 ist mit dem Eingang eines weiteren Verzögerungselementes T6 mit invertiertem Ausgang verbunden, welcher mit einem Eingang 41 des UND Gatters 14 verbunden ist. Der zweite Eingang des UND Gatters 14 und der zweite Eingang des NOR Gatters 13 sind miteinander verbunden, und empfangen ein Steuersignal von einem (nicht gezeigten) Steuersignalgenerator am Steureingang Tin.

Der Steuersignalgenerator erzeugt ein Steuersignal, welches zwischen zwei logischen Zuständen entsprechend der Abwechslung zwischen der Ladephase A und der Entladephase B wechselt, wie in Figur 3 gezeigt ist.

Figur 1 ist eine Tabelle zum Erläutern des Betriebs der Halbleiterschalter SW11 bis SW13 des Schalters SW1 und des Betriebs der Halbleiterschalter SW21 bis SW23 des Schalters SW2, abhängig von dem logischen Zustand des an den Steueranschluß Tin des Schaltkreises der Figur 10 angelegten Steuersignals.

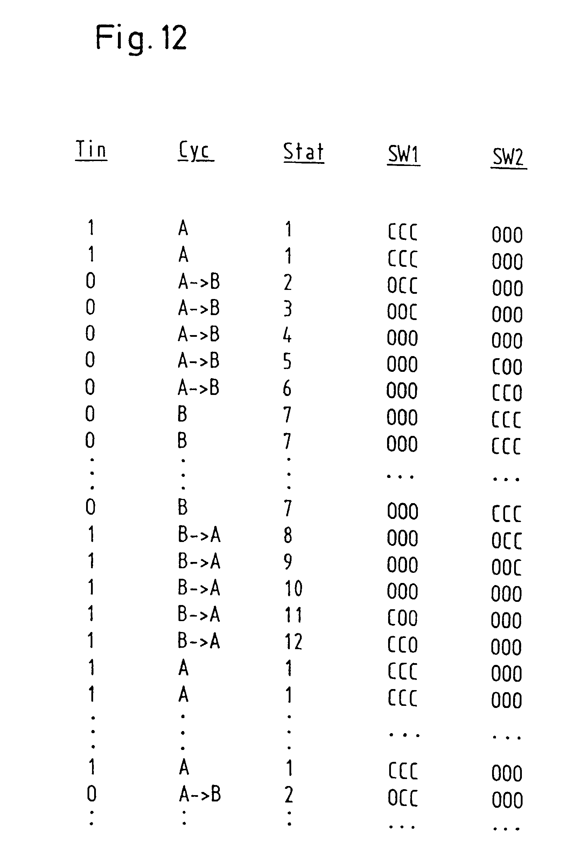

Die Tabelle der Figur 12 zeigt in ihrer linken Spalte Tin den logischen Zustand des Steuersignals Tin. Die nächste Spalte Cyc schließt einen Referenz zur Ladephase A oder Entladephase B ein, abhängig vom Schaltzustand der Schalter SW1 und SW2.

Die nächste Spalte Stat zeigt den Zustand aller sechs Halbleiterschalter SW 11 bis SW13 und SW21 bis SW23 des Schaltkreises der Figur 10. Aus dieser Spalte ist deutlich, daß zwölf verschiedene Schaltzustände unterscheiden werden können.

Schließlich zeigen die Spalten SW1 und SW2 den Schaltzustand eines jeden Halbleiterschalters an. Zu diesem Zweck schließ die Spalte SW1 drei Unterspalten ein, wobei die linke Unterspalte SW11 betrifft, die mittlere Spalte SW12 betrifft und die rechte Spalte SW13 betrifft. In gleicher Weise schließt die Spalte SW2 drei Unterspalten ein, wobei die linke Spalte SW21 betrifft, die mittlere Spalte SW22, und die rechte Spalte SW23 betrifft. Jede der Unterspalten von SW1 und SW₂ kann entweder den Eintrag C haben, was anzeigt, daß der jeweilige Halbleiterschalter im leitenden Zustand ist, oder den Eintrag O, was anzeigt, daß der jeweilige Halbleiterschalter im nicht leitenden Zustand ist, das heißt im geöffneten Zustand. Die folgende Erläuterung beginnt damit, daß der Schalter SW1 im vollständig geschlossen Zustand ist, das heißt, alle Halbleiterschalter von SW 1 sind leitend, während der Schalter SW2 im vollständig geschlossen Zustand ist, das heißt, alle Halbleiterschalter von SW2 sind nicht leitend. Dieser Zustand wird Zustand 1 genannt und entspricht der Ladephase A des Stromversorgungsabschnittes 11.

Mir dem Übergang des Steuersignals Tin von logisch 1 nach logisch 0 treten die Halbleiterschalter von SW1 und SW2 in einen Übergang von Phase A nach Phase B ein, entsprechend den Zuständen 2 bis 6. Mit dem Übergang von Tin von 1 nach 0 geht der Ausgang des UND Gatters 14 ohne wesentliche Verzögerung in den logischen Zustand 0, was darin resultiert, daß der Schalter SW11 nicht leitend wird (Zustand 2). Nach Ablauf der durch T1 bestimmten Verzögerungszeit wird auch der Schalter SW12 nicht leitend (Zustand 3). Nach einer weiteren, durch T2 bestimmten Verzögerung wird der Schalter SW13 nicht leitend (Zustand 4). Dieser Zustand 4 ist ein Zustand, in welchem alle sechs Halbleiterschalter nicht leitend sind, und dient dazu, einen Kurzschluß zwischen den Stromversorgungsanschlüssen 1 und 2 des Stromversorgungsabschnittes 11 aufgrund einer zeitlichen Überlapung der leitenden Zustände von SW1 und SW2 zu vermeiden.

Erst nach Ablauf einer Verzögerungszeit, die durch T3 bestimmt wird, geht der Eingang 31 des NOR Gatters 13 auf niedriges Potential, so daß der Ausgang des NOR Gatters 13 hoch geht und den Schalter SW21 von SW2 leitend macht (Zustand 5). Demgemäß bestimmt die Verzögerungszeit von T3, die Dauer des Zustandes 4. Wenn das Verzögerungselement T3 nicht vorhanden ist, folgt der Zustand 5 im wesentlichen sofort auf den Zustand 3, was in einer zeitlichen Überlappung des leitenden Zustandes des Schalters SW13 und SW21 resultieren kann. Solch eine Überlappung kann mittels des Verzögerungselementes T3 vermieden werden. Das Verzögerungselement T4 verzögert das Steuersignal, welches den Schaltzustand von SW21 steuert, und nach Ablauf einer Verzögerungszeit, die durch T4 bestimmt wird, geht der Schalter SW22 in den leitenden Zustand (Zustand 6). Nach einer weiteren, durch T5 bestimmten Verzögerung geht SW23 in den leitenden Zustand (Zustand 7), womit der Übergang zwischen der Ladepahse A und der Entladephase beendet ist. Zustand 7 entsprechend der Entladephase B wird fortgesetzt, solange wie das Steuersignal am Anschluß Tin logisch 0 ist.

Mit dem Übergang des Steuersignals Tin von logisch 0 nach logisch 1 geht der Ausgang des NOR Gatters auf logisch 0, so daß der Halbleiterschalter SW21 ohne wesentliche Verzögerung nicht leitend wird. Der Übergang von Tin von 0 nach 1 initiert den Übergang von der Entladephase B zur Ladephase A entsprechend den Zuständen 8 bis 12. Während der Übergang von Tin von 0 nach 1 einen im wesentlichen sofortigen Effekt auf den Zustand des Schalters SW21 hat, verbleibt der Schalter SW11 momentan nicht leitend, weil der Ausgang des UND-Gatters 14 unabhängig vom logischen Zustand von Tin logisch 0 ist, weil der Ausgang von T6 nach Ablauf einer durch das Verzögerungselement T6 bestimmten Verzögerungszeit, nachdem der Halbleiterschalter SW23 leitend geworden ist, auf 0 gegangen ist, und somit der Ausgang des UND Gatters 14 auf logisch 0 verriegelt wird. Nach Ablauf der durch T4 bestimmten Verzögerungszeit wird SW 22 nicht leitend (Zustand 9), und nach einer weiteren, durch T5 bestimmten Verzögerung wird der Schalter SW23 nicht leitend (Zustand 10). Zustand 10 entspricht Zustand 4 darin, daß alle Halbleiterschalter nun in dem nicht leitenden Zustand sind.

Nach Ablauf einer durch T6 bestimmten Verzögerungszeit geht der Eingang 41 des UND Gatters 14 auf logisch 1, was dazu führt, daß der Ausgang des UND Gatters 14 logisch 1 wird und den Schalter SW11 leitend macht (Zustand 11). Demgemäß bestimmt die durch T6 bewirkte Verzögerung die Dauer des Zustandes 10, in welchem alle Halbleiterschalter SW11 bis SW13 und SW21 bis SW23 nicht leitend sind. Auf diese Weise vermeidet das Verzögerungselement T6 eine Überlappung der leitenden Zustände von SW23 und SW11.

Das Verzögerungselement T1 verzögert das Steuersignal, das den Schalter SW11 leitend machte, um eine vorbestimmte Verzögerungszeit und macht dann den Halbleiterschalter SW12 leitend (Zustand 12). Nach Ablauf einer weiteren, durch T2 bestimmten Verzögerungszeit wird Halbleiterschalter SW13 leitend. Nun ist der Übergang von der Entladephase B zur Ladephase A abgeschlossen, und die Halbleiterschalter sind im Zustand 1 bis zur nächsten Änderung von Tin von 1 nach 0, womit ein voller Lade- und Entladezyklus abgeschlossen ist.

Dadurch, daß jeder der Schalter SW1 und SW2 eine Vielzahl von parallel geschalteten Halbleiterschaltern umfaßt, ist es möglich, die Gestalt des Stromverlaufs während des Übergangs zwischen der Ladephase und der Entladephase oder umgekehrt zu steuern. Auf diese Weise können Stromspitzen, welche Störsignale in dem Stromversorgungssystem bewirken, unterdrückt werden. Die Wellenform des durch SW1 und SW2 geschalteten Stromes kann mittels geeigneter Wahl der Werte für jede der Impedanzen R10, R20, R30 von SW1 und R40, R50 und R60 von SW2 geformt werden.

Ferner vermeiden die Verzögerungselemente T3 und T6 zuverlässig eine zeitliche Überlappung der leitenden Zustände von SW1 und SW2 und sorgen für eine zeitliche Überlappung der nichtleitenden Zustände von SW1 und SW2, deren Dauer gut gesteuert werden kann.

Fig. 11 zeigt ein Ausführungsbeispiel von Steuereinrichtungen zum Steuern des Schaltzustandes der Schalter SW1a, SWlb, SW2a und SW2b des Stromversorgungsabschnittes 11 gemäß dem vierten Ausführungsbeispiel der vorliegenden Erfindung. Ähnlich dem Ausführungsbeispiel der Fig. 10 umfaßt jeder der Schalter SW1a, SW1b, SW2a und SW2b eine Vielzahl von parallel geschalteten Halbleiterschaltern. Insbesondere umfaßt der Schalter SWla die Halbleiterschalter SW14, SW15 und SW16. Der Schalter SW1b umfaßt die Halbleiterschalter SW17, SW18 und SW19. Der Schalter SW2a umfaßt die Halbleiterschalter SW24, SW25 und SW26. Der Schalter SW2b umfaßt die Halbleiterschalter SW27, SW28 und SW29. Die Impedanzen Rll, R21, R31, R41, R51, R61, R71, R81, R91, R101, R111 und R121 stellen die EIN-Impedanzen der jeweiligen Halbleiterschalter dar.

Ähnlich dem Ausführungsbeispiel der Fig. 10 zeigt Fig. 12 einen Steuerschaltkreis, welcher Verzögerungselemente T1 bis T3 und T4 bis T6 umfaßt, ein NOR-Gatter 13 und ein UND-Gatter 14. Die Verbindung dieser Elemente untereinander ist identisch mit dem, was unter Bezugnahme auf Fig. 10 beschrieben wurde. In Fig. 11 steuert der Ausgang des UND-Gatters 14 den Schaltzustand der Schalter SW14 und SW17, der Ausgang des Verzögerungselementes T1 steuert den Schaltzustand von SW15 und SW18, während der Ausgang des Verzögerungselementes T2 den Schaltzustand von SW16 und SW19 steuert. Der Ausgang des NOR-Gatters 13 steuert den Schaltzustand von SW24 und SW27, der Ausgang des Verzögerungselementes T4 steuert den Schaltzstand von SW25 und SW28, während der Ausgang von T5 den Schaltzustand von SW26 und SW29 steuert. Der Pfeil oberhalb SW17 zeigt an, daß dasselbe Steuersignal, welches SW14 steuert, auch SW17 steuert, so daß die Schaltzustände von SW14 und SW17 immer identisch sind. Der Pfeil oberhalb SW18 zeigt an, daß dasselbe Steuersignal, welches SW15 steuert, ebenfalls SW18 steuert, so daß die Schaltzustände von SW15 und SW18 immer identisch sind. Mutatis mutandis gilt dasselbe für die Halbleiterschalter SW19 und SW27-SW29.

Betreffend die Steuerung der Schalter SWla, SWlb und SW2a, SW2b wird auf die Tabelle der Fig. 12 Bezug genommen. Die Erläuterungen mit Bezug auf Fig. 12, welche für das Ausführungsbeispiel der Fig. 10 gegeben wurden, gelten ebenfalls für das Ausführungsbeispiel der Fig. 11, außer daß die linke Unterspalte der Spalte SW1 in Fig. 12 nun den Schaltzustand von SW14 und von SW17 bezeichnet, die mittlere Spalte den Schaltzustand von SW15 und SW18 bezeichnet, und die rechte Spalte den Schaltzustand von SW16 und SW19 bezeichnet. In gleicher Weise bezeichnet die linke Spalte von SW₂ den Schaltzustand von SW24 und SW27. Die mittlere Spalte bezeichnet den Schaltzustand von SW25 und SW28. Die rechte Unterspalte bezeichnet den Schaltzustand von SW26 und SW29. Die Zustandssequenz von Zustand 1 bis Zustand 12 und zurück zu Zustand 1 entspricht vollständig dem, was betreffend das Ausführungsbeispiel der Fig. 10 beschrieben worden ist. In Fig. 11 stellen die Verzögerungselemente T3 und T6 sicher, daß keine zeitliche Überlappung zwischen der Ladephase A und der Entladephase B besteht. Mit anderen Worten ermöglichen die Verzögerungselemente T3 und T6, daß die Schalter SWla, SW1b und SW2a, SW2b so gesteuert werden, daß die Eingangsanschlüsse 1, 2 immer von den Ausgangsanschlüssen 3, 4 des Stromversorgungsabschnittes 11 des vierten Ausführungsbeispiels mittels der Schalter SW1a, SW1b und SW2a, SW2b getrennt sind. Ähnlich dem Ausführungsbeispiel der Fig. 10 ermöglicht die geeignete Wahl der EIN-Impedanzen der Halbleiterschalter in Fig. 11, die Wellenform des Versorgungsstroms zu formen, um störende Stromspitzen in dem Stromversorgungssystem zu vermeiden.

Die Halbleiterschalter, welche SW1, SW2 in Fig. 10 bilden, oder SW1a, SW1b, SW2a, SW2b in Fig. 11 bilden, können MOSFETs sein, deren Gates als die jeweiligen Steueranschlüsse wirken und deren Kanäle als Schalter wirken.

Die Verzögerungselemente T1 bis T6 können als eine Kette von Invertern ausgeführt sein, wobei jeder Inverter einen Kondensator treibt, der zwischen seinen Ausgang und einen der Stromversorgungsanschlüsse 1, 2 geschaltet ist.

## Patentansprüche

1. Ausgangspufferschaltkreis zum Ausgeben von digitalen Signalen, mit
- einem Pufferverstärkerabschnitt (12) zum Treiben einer symmetrischen Übertragungsleitung niedriger Impedanz und einem Stromversorgungsabschnitt (11) zum Liefern von Leistung an den Pufferverstärkerabschnitt (12);
- wobei der Stromversorgungsabschnitt (11) umfaßt:
-- ein Paar von Eingangsanschlüssen (1, 2) zur Verbindung mit einer Spannungsquelle (V_{CC}) und ein Paar von Ausgangsanschlüssen (3, 4), die mit dem Verstärkerabschnitt (12) verbunden sind;
-- Reaktanzeinrichtungen (L) zum zeitweiligen Speichern von Energie;
-- Schalteinrichtungen (SW), die angepaßt sind, eine Ladephase (A) vorzusehen, in welcher Energie von der Spannungsquelle (V_{CC}) in die Reaktanzeinrichtungen geladen wird, sowie eine Entladephase (B), in welcher wenigstens ein Teil der in den Reaktanzeinrichtungen (L) gespeicherten Energie in die Ausgangsanschlüsse (3, 4) entladen wird;
-- wobei der Verstärkerabschnitt (12) und wenigstens die Schalteinrichtungen (SW) des Stromversorgungsabschnittes (11) auf einem gemeinsamen Halbleiterchip integriert sind.

2. Ausgangspufferschaltkreis nach Anspruch 1,
dadurch **gekennzeichnet**, daß die Schalteinrichtungen (SW) angepaßt sind, eine Trennung beider Eingangsanschlüsse (1, 2) von beiden Ausgangsanschlüssen (3, 4) sowohl während der Ladephase als auch der Entladephase vorzusehen.

3. Ausgangspufferschaltkreis nach Anspruch 2,
dadurch **gekennzeichnet**, daß die Schalteinrichtungen (SW) umfassen:
- ein erstes Paar von Schaltern (SW1a, SW1b) zum Verbinden der Reaktanzeinrichtungen (L) mit den Eingangsanschlüssen (1, 2) in der Ladephase und zum Trennen der Reaktanzeinrichtungen von den Eingangsanschlüssen (1, 2) in der Entladephase; und
- ein zweites Paar von Schaltern (SW2a, SW2b) zum Verbinden der Reaktanzeinrichtungen (L) mit den Ausgangsanschlüssen (3, 4) in der Entladephase und zum Trennen der Ausgangsanschlüsse (3, 4) von den Reaktanzeinrichtungen (L) in der Ladephase.

4. Ausgangspufferschaltkreis nach Anspruch 3,
dadurch **gekennzeichnet**, daß
- ein erster Schalter (SW1a) des ersten Paares von Schaltern (SW1) und ein erster Schalter (SW2b) des zweiten Paares von Schaltern in Reihe geschaltet sind, mit einem ersten Verbindungspunkt (110) dazwischen;
- ein zweiter Schalter (SW1b) des ersten Paares von Schaltern (SW1) und ein zweiter Schalter (SW2a) des zweiten Paares von Schaltern (SW2) in Reihe geschaltet sind, mit einem zweiten Verbindungspunkt (22) dazwischen; und
- ein erster bzw. zweiter Anschluß der Reaktanzeinrichtungen (L) mit dem ersten bzw. zweiten Verbindungspunkt verbunden ist.

5. Ausgangspufferschaltkreis nach Anspruch 3 oder 4,
dadurch **gekennzeichnet**, daß einige oder alle der Schalter (SW) Halbleiterschalter umfassen.

6. Ausgangspufferschaltkrels nach Anspruch 5,
dadurch **gekennzeichnet**, daß die Schalter des zweiten Paares (SW2) Dioden sind, die geschaltet sind, in der Entladephase in Vorwärtsrichtung vorgespannt zu sein, und in der Ladephase in Rückwärtsrichtung vorgespannt zu sein.

7. Ausgangspufferschaltkreis nach Anspruch 5,
dadurch **gekennzeichnet**, daß jeder Halbleiterschalter (SW1a, SW1b, SW2a, SW2b) eine Vielzahl von Feldeffekttransistoren umfaßt, deren Kanäle parallel geschaltet sind.

8. Ausgangspufferschaltkreis nach Anspruch 7,
dadurch **gekennzeichnet**, daß
- jedes Paar von Halbleiterschaltern (SW1, SW2) eine Kette von Verzögerungsschaltkreisen (T1, T2; T4, T5) zum Verzögern eines Steuersignals umfaßt, welches den Schaltzustand der Halbleiterschalter steuert; und
- die Steuergates der Feldeffekttransistoren eines jeden Paares von Halbleiterschaltern mit der jeweiligen Kette von Verzögerungsschaltkreisen verbunden sind.

9. Ausgangspufferschaltkreis nach Anspruch 1,
dadurch **gekennzeichnet**, daß
- die Schalteinrichtungen (SW) einen ersten Halbleiterschalter (SW1) zum Durchführen der Ladephase und einen zweiten Halbleiterschalter (SW2) zum Durchführen der Entladephase umfassen;
- der erste Schalter (SW1) zwischen einen Eingangsanschluß (1) des Paares von Eingangsanschlüssen (1, 2) und einen ersten Anschluß der Reaktanzeinrichtungen (L) geschaltet ist;
- der zweite Schalter (SW2) zwischen den ersten Anschluß der Reaktanzeinrichtungen (L) und einen Ausgangsanschluß (3) des Paares von Ausgangsanschlüssen (3, 4) geschaltet ist;
- wobei ein zweiter Anschluß der Reaktanzeinrichtungen (L) mit dem anderen Ausgangsanschluß (4) des Paares von Ausgangsanschlüssen (3, 4) verbunden ist.

10. Ausgangspufferschaltkreis nach Anspruch 9,
dadurch **gekennzeichnet**, daß
- der eine Ausgangsanschluß (3) mit dem anderen Eingangsanschluß (2) des Paares von Eingangsanschlüssen (1, 2) verbunden ist.

11. Ausgangspufferschaltkreis nach Anspruch 9,
dadurch **gekennzeichnet**, daß
- der eine Ausgangsanschluß (3) mit einem ersten Anschluß einer Spannungsquelle (V_{off}) verbunden ist, deren zweiter Anschluß mit dem anderen Eingangsanschluß (2) des Paares von Eingangsanschlüssen (1, 2) verbunden ist.

12. Ausgangspufferschaltkreis nach Anspruch 11,
dadurch **gekennzeichnet**, daß
- die Spannungsquelle (V_{off}) eine Parallelschaltung eines Kondensators (C2) und einer Diode umfaßt, deren Anode mit dem einen Ausgangsanschluß (3) verbunden ist, und deren Kathode mit dem anderen Eingangsanschluß (2) verbunden ist.

13. Ausgangspufferschaltkreis nach Anspruch 9,
dadurch **gekennzeichnet**, daß
- eine erste Lastimpedanz (R1) zwischen den einen Ausgangsanschluß (3) und den anderen Eingangsanschluß (2) geschaltet ist; und
- eine zweite Lastimpedanz (R2) zwischen den anderen Ausgangsanschluß (4) und den anderen Eingangsanschluß (2) geschaltet ist.

14. Ausgangspufferschaltkreis nach Anspruch 13,
dadurch **gekennzeichnet**, daß
- der Verstärkerabschnitt (12) einschließlich einer Übertragungsleitung (9), die mit den Signalausgangsanschlüssen (5, 6) des Pufferverstärkerabschnittes (12) verbunden ist, die ersten und zweiten Lastimpedanzen (R1, R2) vorsieht; und
- der Abschluß der Übertragungsleitung (9) angepaßt ist, eine Verbindung der ersten und zweiten Lastimpedanzen (R1, R2) mit dem anderen Eingangsanschluß (2) vorzusehen.

15. Ausgangspufferschaltkreis nach einem der Ansprüche 9 bis 14,
dadurch **gekennzeichnet**, daß
- jeder Halbleiterschalter (SW1, SW2) eine Vielzahl von Feldeffekttransistoren umfaßt, deren Kanäle parallel geschaltet sind.

16. Ausgangspufferschaltkreis nach Anspruch 15,
**gekennzeichnet** durch
- eine erste Kette von Verzögerungsschaltkreisen (T1, T2) und eine zweite Kette von Verzögerungsschaltkreisen (T4, T5) zum Verzögern eines Steuersignals (Tin), welches den Schaltzustand der Schalter steuert;
- wobei die Gates der Feldeffekttransistoren des ersten Schalters (SW1) mit der ersten Kette von Verzögerungsschaltkreisen (T1, T2) verbunden sind und die Gates der Feldeffekttransistoren des zweiten Schalters (SW2) mit der zweiten Kette von Verzögerungsschaltkreisen (T4, T5) verbunden sind.

17. Ausgangspufferschaltkreis nach Anspruch 8 oder 16,
dadurch **gekennzeichnet**, daß
- der Ausgang der ersten Kette von Verzögerungsschaltkreisen (T1, T2) mit einem ersten Eingang (31) eines NOR-Gatters (13) mit zwei Eingängen verbunden ist;
- der Ausgang des NOR-Gatters (13) mit dem Eingang der zweiten Kette von Verzögerungsschaltkreisen (T4, T5) verbunden ist;
- der invertierte Ausgang der zweiten Kette von Verzögerungsschaltkreisen (T4, T5) mit einem ersten Eingang (41) eines UND-Gatters (14) mit zwei Eingängen verbunden ist, dessen Ausgang mit dem Eingang der ersten Kette von Verzögerungsschaltkreisen (T1, T2) verbunden ist; und
- der zweite Eingang des NOR-Gatters (13) und der zweite Eingang des UND-Gatters (14) miteinander verbunden sind und angepaßt sind, das Steuersignal (Tin) zu empfangen.

18. Ausgangspufferschaltkreis nach Anspruch 17,
dadurch **gekennzeichnet**, daß
- ein erster Verzögerungsschaltkreis (T3) zwischen den Ausgang der ersten Kette von Verzögerungsschaltkreisen (T1, T2) und den ersten Eingang (31) des NOR-Gatters (13) geschaltet ist; und
- ein zweiter Verzögerungsschaltkreis (T6) zwischen den Ausgang der zweiten Kette von Verzögerungsschaltkreisen und den ersten Eingang (41) des UND-Gatters (14) geschaltet ist.

19. Ausgangspufferschaltkreis nach einem der vorangehenden Ansprüche,
dadurch **gekennzeichnet**, daß
Freilaufdioden (D) über wenigstens einen der Schalter (SW1, SW2, SW1a, SW1b, SW2a, SW2b) geschaltet sind.

20. Ausgangspufferschaltkreis nach einem der vorangehenden Ansprüche,
dadurch **gekennzeichnet**, daß
- der Pufferverstärkerabschnitt (12) ein erstes Paar von Signalschaltern (27, 33; 30, 32) umfaßt, die in Reihe zwischen den ersten Ausgangsanschluß (4) und den zweiten Ausgangsanschluß (3) des Stromversorgungsabschnittes (11) geschaltet sind, sowie ein zweites Paar von Signalschaltern (29, 31; 28, 34), die in Reihe zwischen den ersten Ausgangsanschluß (4) und den zweiten Ausgangsanschluß (3) des Stromversorgungsabschnittes (11) geschaltet sind;
- wobei ein erster Verbindungspunkt zwischen den Signalschaltern (27, 33; 30, 32) des ersten Paares mit einem ersten Signalausgangsanschluß (5) des Pufferverstärkerabschnittes (12) verbunden ist, und ein zweiter Verbindungspunkt zwischen den Signalschaltern (29, 31; 28, 34) des zweiten Paares mit einem zweiten Signalausgangsanschluß (6) des Pufferverstärkerabschnittes (12) verbunden ist;
- wobei Steueranschlüsse der Signalschalter des ersten und zweiten Paares so geschaltet sind, daß
-- wenn ein Eingangssignal (U_{Signal}) des Pufferverstärkerabschnittes (12) einen ersten logischen Pegel annimmt, der erste Signalausgangsanschluß (5) mit dem ersten Ausgangsanschluß (4) des Stromversorgungsabschnittes (11) verbunden wird und der zweite Signalausgangsanschluß (6) mit dem zweiten Ausgangsanschluß (3) des Stromversorgungsabschnittes (11) verbunden wird; und
-- wenn das Eingangssignal (U_{Signal}) des Pufferverstärkerabschnittes (12) einen zweiten logischen Pegel annimmt, der erste Signalausgangsanschluß (5) mit dem zweiten Ausgangsanschluß (3) des Stromversorgungsabschnittes (11) verbunden wird und der zweite Signalausgangsanschluß (6) mit dem ersten Ausgangsanschluß (4) des Stromversorgungsabschnittes (11) verbunden wird.

21. Ausgangspufferschaltkreis nach Anspruch 20,
dadurch **gekennzeichnet**, daß jeder der Signalschalter einen n-Kanal MOSFET und einen p-Kanal MOSFET umfaßt, deren Kanäle parallel geschaltet sind, und deren Gates komplementäre Eingangssignale (S1, S2) empfangen.

22. Ausgangspufferschaltkreis nach Anspruch 21,
dadurch **gekennzeichnet**, daß
- die Gates der p-Kanal MOSFETs (29, 30) des ersten Schalters (29, 31) des zweiten Paares von Signalschaltern und der zweite Schalter (30, 32) des ersten Paares von Signalschaltern, und die Gates der n-Kanal MOSFETs (27, 28) des ersten Schalters (27, 33) des ersten Paares von Signalschaltern und des zweiten Schalters (28, 34) des zweiten Paares von Signalschaltern das Eingangssignal (S1) empfangen; und
- die Gates der p-Kanal MOSFETs (33, 34) des zweiten Schalters (28, 34) des zweiten Paares von Signalschaltern und des ersten Schalters (27, 33) des ersten Paares von Signalschaltern, und die Gates der n-Kanal MOSFETs (31, 32) des zweiten Schalters (30, 32) des ersten Paares von Signalschaltern und des ersten Schalters (29, 31) des zweiten Paares von Signalschaltern das invertierte Eingangssignal (S2) empfangen.

23. Ausgangspufferschaltkreis nach einem der vorangehenden Ansprüche,
dadurch **gekennzeichnet**, daß eine Glättungsreaktanz (C) über die Ausgangsanschlüsse (3, 4) geschaltet ist.

24. Ausgangspufferschaltkreis nach einem der vorangehenden Ansprüche,
dadurch **gekennzeichnet**, daß die Reaktanzeinrichtungen (L) eine Induktivität sind.

25. Ausgangspufferschaltkreis nach einem der vorangehenden Ansprüche,
dadurch **gekennzeichnet**, daß er eine Vielzahl von Verstärkerabschnitten (12) für eine Vielzahl von Signalkanälen umfaßt.

26. Ausgangspufferschaltkreis nach einem der vorangehenden Ansprüche,
**gekennzeichnet** durch Steuereinrichtungen zum Steuern des Schaltbetriebs der Schalter (SW1, SW2, SW1a, SW1b, SW2a, SW2b).

## Claims

1. An output buffer circuit for outputting digital signals comprising
- a buffer amplifier section (12) for driving a balanced transmission line of low impedance, and a current supply section (11) for supplying power to the buffer amplifier section (12);
- wherein the current supply section (11) comprises:
-- a pair of input terminals (1, 2) for connection to a voltage source (V_{cc}) and a pair of output terminals (3, 4) which are connected to the amplifier section (12);
-- reactance devices (L) for the temporary storage of energy;
-- switching devices (SW) adapted to provide a charging phase (A) in which energy is charged from the voltage source (V_{cc}) into the reactance devices, and a discharging phase (B) in which at least a part of the energy stored in the reactance devices (L) is discharged into the output terminals (3, 4);
-- wherein the amplifier section (12) and at least the switching devices (SW) of the current supply section (11) are integrated on a common semiconductor chip.

2. An output buffer circuit according to Claim 1, characterised in that the switching devices (SW) are adapted to provide for the isolation of the two input terminals (1, 2) from the two output terminals (3, 4) both during the charging phase and the discharging phase.

3. An output buffer circuit according to Claim 2, characterised in that the switching devices (SW) comprise:
- a first pair of switches (SW1a, SW1b) for connecting the reactance devices (L) to the input terminals (1, 2) in the charging phase and for disconnecting the reactance devices from the input terminals (1, 2) in the discharging phase; and
- a second pair of switches (SW2a, SW2b) for connecting the reactance devices (L) to the output terminals (3, 4) in the discharging phase and for disconnecting the output terminals (3, 4) from the reactance devices (L) in the charging phase.

4. An output buffer circuit according to Claim 3, characterised in that
- a first switch (SW1a) of the first pair of switches (SW1) and a first switch (SW2b) of the second pair of switches are connected in series, with a first connection point (110) in between;
- a second switch (SW1b) of the first pair of switches (SW1) and a second switch (SW2a) of the second pair of switches (SW2) are connected in series, with a second connection point (22) in between; and
- a first and second terminal of the reactance devices (L) are connected to the first and second connection point respectively.

5. An output buffer circuit according to Claim 3 or 4, characterised in that some or all of the switches (SW) comprise semiconductor switches.

6. An output buffer circuit according to Claim 5, characterised in that the switches of the second pair (SW2) are diodes which are connected to be biased in the forwards direction in the discharging phase and biased in the backwards direction in the charging phase.

7. An output buffer circuit according to Claim 5, characterised in that each semiconductor switch (SW1a, SW1b, SW2a, SW2b) comprises a plurality of field effect transistors whose channels are connected in parallel.

8. An output buffer circuit according to Claim 7, characterised in that
- each pair of semiconductor switches (SW1, SW2) comprises a chain of delay circuits (T1, T2; T4, T5) for delaying a control signal which controls the switching state of the semiconductor switches; and
- the control gates of the field effect transistors of each pair of semiconductor switches are connected to the respective chain of delay circuits.

9. An output buffer circuit according to Claim 1, characterised in that
- the switching devices (SW) comprise a first semiconductor switch (SW1) for executing the charging phase and a second semiconductor switch (SW2) for executing the discharging phase;
- the first switch (SW1) is connected between one input terminal (1) of the pair of input terminals (1, 2) and a first terminal of the reactance devices (L) ;
- the second switch (SW2) is connected between the first terminal of the reactance devices (L) and one output terminal (3) of the pair of output terminals (3, 4);
- where a second terminal of the reactance devices (L) is connected to the other output terminal (4) of the pair of output terminals (3, 4).

10. An output buffer circuit according to Claim 9, characterised in that
- the one output terminal (3) is connected to the other input terminal (2) of the pair of input terminals (1, 2).

11. An output buffer circuit according to Claim 9, characterised in that
- the one output terminal (3) is connected to a first terminal of a voltage source (V_{off}) whose second terminal is connected to the other input terminal (2) of the pair of input terminals (1, 2).

12. An output buffer circuit according to Claim 11, characterised in that
- the voltage source (V_{off}) comprises a parallel connection of a capacitor (C2) and a diode whose anode is connected to the one output terminal (3) and whose cathode is connected to the other input terminal (2).

13. An output buffer circuit according to Claim 9, characterised in that
- a first load impedance (R1) is connected between the one output terminal (3) and the other input terminal (2); and
- a second load impedance (R2) is connected between the other output terminal (4) and the other input terminal (2) .

14. An output buffer circuit according to Claim 13, characterised in that.
- the amplifier section (12), including a transmission line (9) which is connected to the signal output terminals (5, 6) of the buffer amplifier section (12), provides the first and second load impedances (R1, R2); and
- the termination of the transmission line (9) is adapted to provide a connection between the first and second load impedances (R1, R2) and the other input terminal (2).

15. An output buffer circuit according to one of Claims 9 to 14, characterised in that
- each semiconductor switch (SW1, SW2) comprises a plurality of field effect transistors whose channels are connected in parallel.

16. An output buffer circuit according to Claim 15, characterised by
- a first chain of delay circuits (T1, T2) and a second chain of delay circuits (T4, T5) for delaying a control signal (Tin) which controls the switching state of the switches;
- wherein the gates of the field effect transistors of the first switch (SW1) are connected to the first chain of delay circuits (T1, T2) and the gates of the field effect transistors of the second switch (SW2) are connected to the second chain of delay circuits (T4, T5).

17. An output buffer circuit according to Claim 8 or 16, characterised in that
- the output of the first chain of delay circuits (T1, T2) is connected to a first input (31) of a NOR-gate (13) with two inputs;
- the output of the NOR-gate (13) is connected to the input of the second chain of delay circuits (T4, T5) ;
- the inverted output of the second chain of delay circuits (T4, T5) is connected to a first input (41) of an AND-gate (14) with two inputs, the output of which is connected to the input of the first chain of delay circuits (T1, T2); and
- the second input of the NOR-gate (13) and the second input of the AND-gate (14) are connected to one another and are adapted to receive the control signal (Tin).

18. An output buffer circuit according to Claim 17, characterised in that
- a first delay circuit (T3) is connected between the output of the first chain of delay circuits (T1, T2) and the first input (31) of the NOR-gate (13); and
- a second delay circuit (T6) is connected between the output of the second chain of delay circuits and the first input (41) of the AND-gate (14).

19. An output buffer circuit according to one of the preceding claims, characterised in that freewheeling diodes (D) are connected via at least one of the switches (SW1, SW2, SW1a, SW1b, SW2a, SW2b).

20. An output buffer circuit according to one of the preceding claims, characterised in that
- the buffer amplifier section (12) comprises a first pair of signal switches (27, 33; 30, 32) which are connected in series between the first output terminal (4) and the second output terminal (3) of the current supply section (11), and a second pair of signal switches (29, 31; 28, 34) which are connected in series between the first output terminal (4) and the second output terminal (3) of the current supply section (11);
- wherein a first connection point between the signal switches (27, 33;, 30, 32) of the first pair is connected to a first signal output terminal (5) of the buffer amplifier section (12), and a second connection point between the signal switches (29, 31; 28, 34) of the second pair is connected to a second signal output terminal (6) of the buffer amplifier section (12);
- wherein control terminals of the signal switches of the first and second pair are connected such that
-- when an input signal (U_{Signal}) of the buffer amplifier section (12) assumes a first logical level, the first signal output terminal (5) is connected to the first output terminal (4) of the current supply section (11) and the second signal output terminal (6) is connected to the second output terminal (3) of the current supply section (11); and
-- when the input signal (U_{Signal}) of the buffer amplifier section (12) assumes a second logic level, the first signal output terminal (5) is connected to the second output terminal (3) of the current supply section (11) and the second signal output terminal (6) is connected to the first output terminal (4) of the current supply section (11) .

21. An output buffer circuit according to Claim 20, characterised in that each of the signal switches comprises a n-channel MOSFET and a p-channel MOSFET whose channels are connected in parallel and whose gates receive complementary input signals (S1, S2).

22. An output buffer circuit according to Claim 21, characterised in that
- the gates of the p-channel MOSFETs (29, 30) of the first switch (29, 31) of the second pair of signal switches and of the second switch (30, 32) of the first pair of signal switches, and the gates of the n-channel MOSFETs (27, 28) of the first switch (27, 33) of the first pair of signal switches and of the second switch (28, 34) of the second pair of signal switches receive the input signal (S1); and
- the gates of the p-channel MOSFETs (33, 34) of the second switch (28, 34) of the second pair of signal switches and of the first switch (27, 33) of the first pair of signal switches, and the gates of the n-channel MOSFETs (31, 32) of the second switch (30, 32) of the first pair of signal switches and of the first switch (29, 31) of the second pair of signal switches receive the inverted input signal (S2).

23. An output buffer circuit according to one of the preceding claims, characterised in that a smoothing reactance (C) is connected via the output terminals (3, 4).

24. An output buffer circuit according to one of the preceding claims, characterised in that the reactance devices (L) are an inductance.

25. An output buffer circuit according to one of the preceding claims, characterised in that it comprises a plurality of amplifier sections (12) for a plurality of signal channels.

26. An output buffer circuit according to one of the preceding claims, characterised by control devices for controlling the switching operation of the switches (SW1, SW2, SW1a, SW1b, SW2a, SW2b).

## Revendications

1. Circuit tampon de sortie pour délivrer des signaux numériques,
- comportant une partie amplification de tampon (12) pour attaquer une ligne de transmission symétrique de basse impédance et une partie alimentation en courant (11) pour délivrer une puissance à la partie amplification de tampon (12) ;
- dans lequel la partie alimentation en courant (11) comprend :
-- une paire de bornes d'entrée (1, 2) pour la liaison avec une source de tension (V_{cc}) et une paire de bornes de sortie (3, 4) qui sont reliées à la partie amplification (12) ;
-- des dispositifs à réactance (L) pour l'accumulation temporaire d'énergie ;
-- des dispositifs de commutation (SW) qui sont adaptés pour prévoir une phase de charge (A) dans laquelle de l'énergie est chargée de la source de tension (V_{CC}) dans les dispositifs à réactance ainsi qu'une phase de décharge (B) dans laquelle au moins une partie de l'énergie accumulée dans les dispositifs à réactance (L) est déchargée dans les bornes de sortie (3, 4) ;
-- la partie amplification (12) et au moins les dispositifs de commutation (SW) de la partie alimentation en courant (11) étant intégrés sur une puce à semi-conducteurs commune.

2. Circuit tampon de sortie selon la revendication 1, caractérisé en ce que les dispositifs de commutation (SW) sont adaptés pour prévoir une séparation des deux bornes d'entrée (1, 2) des deux bornes de sortie (3, 4) aussi bien pendant la phase de charge que pendant la phase de décharge.

3. Circuit tampon de sortie selon la revendication 2, caractérisé en ce que les dispositifs de commutation (SW) comprennent :
- une première paire d'interrupteurs (SW1a, SW1b) pour relier les dispositifs à réactance (L) aux bornes d'entrée (1, 2) dans la phase de charge et pour séparer les dispositifs à réactance des bornes d'entrée (1, 2) dans la phase de décharge ;
- une deuxième paire d'interrupteurs (SW2a, SW2b) pour relier les dispositifs à réactance (L) aux bornes de sortie (3, 4) dans la phase de décharge et pour séparer les bornes de sortie (3, 4) des dispositifs à réactance (L) dans la phase de charge.

4. Circuit tampon de sortie selon la revendication 3, caractérisé en ce qu'
- un premier interrupteur (SW1a) de la première paire d'interrupteurs (SW1) et un premier interrupteur (SW2b) de la deuxième paire d'interrupteurs sont branchés en série, avec un point de jonction (110) entre eux ;
- un deuxième interrupteur (SW1b) de la première paire d'interrupteurs (SW1) et un deuxième interrupteur (SW2a) de la deuxième paire d'interrupteurs (SW2) sont branchés en série, avec un deuxième point de jonction (22) entre eux ; et
- une première borne des dispositifs à réactance (L) est reliée au premier point de jonction et une deuxième borne au deuxième point de jonction.

5. Circuit tampon de sortie selon la revendication 3 ou 4, caractérisé en ce que quelques-uns ou tous les interrupteurs (SW) comprennent des interrupteurs à semi-conducteurs.

6. Circuit tampon de sortie selon la revendication 5, caractérisé en ce que les interrupteurs de la deuxième paire (SW2) sont des diodes qui sont branchées pour être polarisées dans le sens direct pendant la phase de décharge et pour être polarisées en sens inverse pendant la phase de charge.

7. Circuit tampon de sortie selon la revendication 5, caractérisé en ce que chaque interrupteur à semi-conducteurs (SW1a, SW1b, SW2a, SW2b) comprend plusieurs transistors à effet de champ dont les canaux sont branchés en parallèle.

8. Circuit tampon de sortie selon la revendication 7, caractérisé en ce que
- chaque paire d'interrupteurs à semi-conducteurs (SW1, SW2) comprend une chaîne de circuits de retardement (T1, T2 ; T4, T5) pour retarder un signal de commande qui commande l'état de commutation des interrupteurs à semi-conducteurs ; et
- les grilles de commande des transistors à effet de champ de chaque paire d'interrupteurs à semi-conducteurs sont reliées à la chaîne respective de circuits de retardement.

9. Circuit tampon de sortie selon la revendication 1, caractérisé en ce que
- les dispositifs de commutation (SW) comprennent un premier interrupteur à semi-conducteurs (SW1) pour la mise en oeuvre de la phase de charge et un deuxième interrupteur à semi-conducteurs (SW2) pour la mise en oeuvre de la phase de décharge ;
- le premier interrupteur (SW1) est branché entre une borne d'entrée (1) de la paire de bornes d'entrée (1, 2) et une première borne des dispositifs à réactance (L) ;
- le deuxième interrupteur (SW2) est branché entre la première borne des dispositifs à réactance (L) et une borne de sortie (3) de la paire de bornes de sortie (3, 4) ;
- une deuxième borne des dispositifs à réactance (L) étant reliée à l'autre borne de sortie (4) de la paire de bornes de sortie (3, 4).

10. Circuit tampon de sortie selon la revendication 9, caractérisé en ce que
- la première borne de sortie (3) est reliée à l'autre borne d'entrée (2) de la paire de bornes d'entrée (1, 2).

11. Circuit tampon de sortie selon la revendication 9, caractérisé en ce que
- la première borne de sortie (3) est reliée à une première borne d'une source de tension (V_{off}) dont la deuxième borne est reliée à l'autre borne d'entrée (2) de la paire de bornes d'entrée (1, 2).

12. Circuit tampon de sortie selon la revendication 11, caractérisé en ce que
- la source de tension (V_{off}) comprend un circuit parallèle composé d'un condensateur (C2) et d'une diode dont l'anode est reliée à la première borne de sortie (3) et dont la cathode est reliée à l'autre borne d'entrée (2).

13. Circuit tampon de sortie selon la revendication 9, caractérisé en ce que
- une première impédance de charge (R1) est branchée entre la première borne de sortie (3) et l'autre borne d'entrée (2); et
- une deuxième impédance de charge (R2) est branchée entre l'autre borne de sortie (4) et l'autre borne d'entrée (2).

14. Circuit tampon de sortie selon la revendication 13, caractérisé en ce que
- la partie amplification (12) y compris une ligne de transmission (9), qui est reliée aux bornes de sortie de signaux (5, 6) de la partie amplification de tampon (12), prévoit la première et la deuxième impédance de charge (R1, R2) ; et
- la terminaison de la ligne de transmission (9) est adaptée pour prévoir une liaison de la première et de la deuxième impédance de charge (R1, R2) à l'autre borne d'entrée (2).

15. Circuit tampon de sortie selon l'une des revendications 9 à 14, caractérisé en ce que
- chaque interrupteur à semi-conducteurs (SW1, SW2) comprend plusieurs transistors à effet de champ dont les canaux sont branchés en parallèle.

16. Circuit tampon de sortie selon la revendication 15, caractérisé par
- une première chaîne de circuits de retardement (T1, T2) et par une deuxième chaîne de circuits de retardement (T4, T5) pour retarder un signal de commande (Tin) qui commande l'état de commutation des interrupteurs ;
- les grilles des transistors à effet de champ du premier interrupteur (SW1) étant reliées à la première chaîne de circuits de retardement (T1, T2) et les grilles des transistors à effet de champ du deuxième interrupteur (SW2) étant reliées à la deuxième chaîne de circuits de retardement (T4, T5).

17. Circuit tampon de sortie selon la revendication 8 ou 16, caractérisé en ce que
- la sortie de la première chaîne de circuits de retardement (T1, T2) est reliée à une première entrée (31) d'une porte NON-OU (13) comportant deux entrées ;
- la sortie de la porte NON-OU (13) est reliée à l'entrée de la deuxième chaîne de circuits de retardement (T4, T5) ;
- la sortie inversée de la deuxième chaîne de circuits de retardement (T4, T5) est reliée à une entrée (41) d'une porte ET (14) qui comporte deux entrées et dont la sortie est reliée à l'entrée de la première chaîne de circuits de retardement (T1, T2) ; et
- la deuxième entrée de la porte NON-OU (13) et la deuxième entrée de la porte ET (14) sont reliées entre elles et sont adaptées pour recevoir le signal de commande (Tin).

18. Circuit tampon de sortie selon la revendication 17, caractérisé en ce qu'
- un premier circuit de retardement (T3) est branché entre la sortie de la première chaîne de circuits de retardement (T1, T2) et la première entrée (31) de la porte NON-OU (13) ; et
- un deuxième circuit de retardement (T6) est branché entre la sortie de la deuxième chaîne de circuits de retardement et la première entrée (41) de la porte ET (14).

19. Circuit tampon de sortie selon l'une des revendications précédentes, caractérisé en ce que des diodes de roue libre (D) sont branchées sur au moins l'un des interrupteurs (SW1, SW2, SW1a, SW1b, SW2a, SW2b).

20. Circuit tampon de sortie selon l'une des revendications précédentes, caractérisé en ce que
- la partie amplification de tampon (12) comprend une première paire d'interrupteurs de signaux (27, 33 ; 30, 32) qui sont branchés en série entre la première borne de sortie (4) et la deuxième borne de sortie (3) de la partie alimentation en courant (11) ainsi qu'une deuxième paire d'interrupteurs de signaux (29, 31 ; 28, 34) qui sont branchés en série entre la première borne de sortie (4) et la deuxième borne de sortie (3) de la partie alimentation en courant (11) ;
- un premier point de jonction entre les interrupteurs de signaux (27, 33 ; 30, 32) de la première paire étant relié à une première borne de sortie de signaux (5) de la partie amplification de tampon (12) et un deuxième point de jonction entre les interrupteurs de signaux (29, 31 ; 28, 34) de la deuxième paire étant relié à une deuxième borne de sortie de signaux (6) de la partie amplification de tampon (12) ;
- des bornes de commande des interrupteurs de signaux de la première et de la deuxième paire étant branchées de telle sorte que,
-- si un signal d'entrée (U_{Signal}) de la partie amplification de tampon (12) prend un premier état logique, la première borne de sortie de signaux (5) est reliée à la première borne de sortie (4) de la partie alimentation en courant (11) et la deuxième borne de sortie de signaux (6) est reliée à la deuxième borne de sortie (3) de la partie alimentation en courant (11) ; et
-- si le signal d'entrée (U_{Signal}) de la partie amplification de tampon (12) prend un deuxième état logique, la première borne de sortie de signaux (5) est reliée à la deuxième borne de sortie (3) de la partie alimentation en courant (11) et la deuxième borne de sortie de signaux (6) est reliée à la première borne de sortie (4) de la partie alimentation en courant (11).

21. Circuit tampon de sortie selon la revendication 20, caractérisé en ce que chacun des interrupteurs de signaux comprend un MOSFET à canal n et un MOSFET à canal p dont les canaux sont branchés en parallèle et dont les grilles reçoivent des signaux d'entrée complémentaires (S1, S2).

22. Circuit tampon de sortie selon la revendication 21, caractérisé en ce que
- les grilles des MOSFET à canal p (29, 30) du premier interrupteur (29, 31) de la deuxième paire d'interrupteurs de signaux et du deuxième interrupteur (30, 32) de la première paire d'interrupteurs de signaux et les grilles des MOSFET à canal n (27, 28) du premier interrupteur (27, 33) de la première paire d'interrupteurs de signaux et du deuxième interrupteur (28, 34) de la deuxième paire d'interrupteurs de signaux reçoivent le signal d'entrée (S1) ; et
- les grilles des MOSFET à canal p (33, 34) du deuxième interrupteur (28, 34) de la deuxième paire d'interrupteurs de signaux et du premier interrupteur (27, 33) de la première paire d'interrupteurs de signaux et les grilles des MOSFET à canal n (31, 32) du deuxième interrupteur (30, 32) de la première paire d'interrupteurs de signaux et du premier interrupteur (29, 31) de la deuxième paire d'interrupteurs de signaux reçoivent le signal d'entrée inversé (S2).

23. Circuit tampon de sortie selon l'une des revendications précédentes, caractérisé en ce qu'une réactance de lissage (C) est branchée sur les bornes de sortie (3, 4).

24. Circuit tampon de sortie selon l'une des revendications précédentes, caractérisé en ce que les dispositifs à réactance (L) sont une inductance.

25. Circuit tampon de sortie selon l'une des revendications précédentes, caractérisé en ce qu'il comprend plusieurs parties amplification (12) pour plusieurs canaux de signaux.

26. Circuit tampon de sortie selon l'une des revendications précédentes, caractérisé par des dispositifs de commande pour commander le fonctionnement de commutation des interrupteurs (SW1, SW2, SW1a, SW1b, SW2a, SW2b).
